# EUROPÄISCHE PATENTSCHRIFT

(11) **EP 4 113 693 B1**
(45) Veröffentlichungstag und Bekanntmachung des Hinweises auf die Patenterteilung: **17.04.2024**
(21) Anmeldenummer: 21182439.6
(22) Anmeldetag: 29.06.2021
(51) Int. Cl.: H01M 10/42, H02J 7/00, G01R 27/14

(54) **VERFAHREN UND SYSTEM ZUM BESTIMMEN MINDESTENS EINES LEISTUNGSKONTAKTWIDERSTANDS**
METHOD AND SYSTEM FOR DETERMINING AT LEAST ONE POWER CONTACT RESISTANCE
PROCÉDÉ ET SYSTÈME DE DÉTERMINATION D'AU MOINS UNE RÉSISTANCE DE CONTACT DE PUISSANCE

(43) Veröffentlichungstag der Anmeldung: 04.01.2023
(73) Patentinhaber: Andreas Stihl AG & Co. KG, 71336 Waiblingen (DE)
(72) Erfinder: von Hofen, Malte, 70197 Stuttgart (DE); Sämann, Christian, 70372 Stuttgart (DE)
(74) Vertreter: Patentanwälte Ruff, Wilhelm, Beier, Dauster & Partner mbB

(56) Entgegenhaltungen:
- CN-A- 111 141 957
- US-A1- 2005 194 933
- US-B2- 10 516 275

## Beschreibung

### ANWENDUNGSGEBIET UND STAND DER TECHNIK

Die Erfindung bezieht sich auf ein Verfahren und ein System zum Bestimmen mindestens eines Leistungskontaktwiderstands zwischen mindestens einem Packleistungskontakt eines Akkupacks und mindestens einem Geräteleistungskontakt eines elektrisch angetriebenen Bearbeitungsgeräts oder eines Ladegeräts oder mindestens eines dem mindestens einen Leistungskontaktwiderstand korrespondierenden Widerstandswerts.

CN 111 141 957 A zeigt ein Verfahren zum Bestimmen eines Leistungskontaktwiderstands zwischen einem Leistungskontakt eines Akkus und einem Geräteleistungskontakt eines elektrisch angetriebenen Bearbeitungsgeräts oder eines Ladegeräts, bei dem die Verdopplung der Pol-Leitungen genutzt wird um über eine Schleife eine Messung des Kontaktwiderstandes zu ermöglichen.

US 2005/194933 A1 zeigt ein Verfahren zum Bestimmen eines Leistungskontaktwiderstands zwischen einem Leistungskontakt eines Akkus und einem Leistungskontakt eines Ladegeräts, bei dem der Spannungsabfall, der vom Innenwiderstand der Batterie und einem mit der Batterie verbundenen Außenwiderstand verursacht wird, dadurch bestimmt wird, dass der Spannungsabfall durch Subtrahieren der Batteriespannung, die während einer Nicht-Ladeperiode bzw. während einer Ladeperiode bestimmt wird.

US 10 516 275 B2 zeigt einen Packleistungskontakt eines Akkupacks mit einem Geräteleistungskontakt eines elektrisch angetriebenen Bearbeitungsgeräts der einen Kontakt zur Datenübertragung enthält der auch zum Identifizieren mittels eines Kodierwiderstands dient.

### AUFGABE UND LÖSUNG

Der Erfindung liegt als Aufgabe die Bereitstellung eines Verfahrens und eines Systems jeweils zum Bestimmen mindestens eines Leistungskontaktwiderstands zwischen mindestens einem Packleistungskontakt eines Akkupacks und mindestens einem Geräteleistungskontakt eines elektrisch angetriebenen Bearbeitungsgeräts oder eines Ladegeräts oder mindestens eines dem mindestens einen Leistungskontaktwiderstand korrespondierenden Widerstandswerts zugrunde, das jeweils verbesserte Eigenschaften aufweist bzw. hat.

Die Erfindung löst die Aufgabe durch die Bereitstellung eines Verfahrens mit den Merkmalen des Anspruchs 1 und eines Systems mit den Merkmalen des Anspruchs 14. Vorteilhafte Weiterbildungen und/oder Ausgestaltungen der Erfindung sind in den abhängigen Ansprüchen beschrieben.

Das erfindungsgemäße, insbesondere automatische, Verfahren ist zum, insbesondere automatischen und/oder mittelbaren bzw. indirekten, Bestimmen, insbesondere Messen, mindestens eines, insbesondere elektrischen, Leistungskontaktwiderstands, insbesondere mindestens eines Werts mindestens des Leistungskontaktwiderstands, zwischen mindestens einem, insbesondere elektrischen, Packleistungskontakt eines Akkupacks (Englisch: battery pack) und mindestens einem, insbesondere elektrischen, Geräteleistungskontakt eines elektrisch angetriebenen Bearbeitungsgeräts oder eines, insbesondere elektrischen, Ladegeräts oder mindestens eines dem mindestens einen Leistungskontaktwiderstand korrespondierenden Widerstandswerts ausgebildet bzw. konfiguriert bzw. vorgesehen. Der mindestens eine Packleistungskontakt und der mindestens eine Geräteleistungskontakt berühren bzw. kontaktieren einander bzw. sich, insbesondere mechanisch und/oder elektrisch und/oder unmittelbar, und sind mit einem, insbesondere elektrischen, Leistungs- bzw. Betriebsstrom belastet. Der Akkupack und das Bearbeitungsgerät oder das Ladegerät sind mittels einer Datenkommunikationsleitung zum Übertragen bzw. Kommunizieren eines, insbesondere elektrischen, Datenkommunikationssignals elektrisch, insbesondere galvanisch, verbunden. Das Verfahren umfasst bzw. weist, insbesondere den Schritt, auf: Bestimmen, insbesondere automatisches und/oder mittelbares bzw. indirektes Bestimmen und/oder Messen, des mindestens einen Leistungskontaktwiderstands oder des mindestens einen Widerstandswerts mittels Vergleichens einer, insbesondere elektrischen, Signalspannungsgröße, insbesondere eines Werts der Signalspannungsgröße, der Datenkommunikationsleitung und einer, insbesondere elektrischen, Leistungsspannungsgröße, insbesondere eines Werts der Leistungsspannungsgröße, des mindestens einen Packleistungskontakts oder des mindestens einen Geräteleistungskontakts miteinander. Insbesondere entweder, die Signalspannungsgröße oder die Leistungsspannungsgröße, insbesondere selbst, hängt von mindestens einem, insbesondere elektrischen, Spannungsabfall, insbesondere mindestens einem Wert mindestens des Spannungsabfalls, verursacht durch den Leistungsstrom, insbesondere einen Wert des Leistungsstroms, und den mindestens einen Leistungskontaktwiderstand ab.

Dies ermöglicht ein mittelbares und/oder, insbesondere somit, einfaches und/oder kostengünstiges Bestimmen des mindestens einen Leistungskontaktwiderstands oder des mindestens einen Widerstandswerts, insbesondere mit vorhandenen Mitteln.

Insbesondere kann die Datenkommunikationsleitung und/oder, insbesondere somit, die Signalspannungsgröße, insbesondere bereits, vorhanden sein.

Zusätzlich oder alternativ braucht oder kann der mindestens eine Leistungskontaktwiderstand und/oder der mindestens eine Widerstandswert nicht mittels einer, insbesondere getrennten bzw. separaten, Vierpunktmessung, insbesondere mittels zusätzlicher Messkontakte, bestimmt werden.

Weiter zusätzlich oder alternativ braucht oder kann das Datenkommunikationssignal keine Information für und/oder über das Bestimmen des mindestens einen Leistungskontaktwiderstands oder des mindestens einen Widerstandswerts aufweisen. Weiter zusätzlich oder alternativ, insbesondere stattdessen, kann die Signalspannungsgröße von dem mindestens einen Spannungsabfall abhängen.

Das Datenkommunikationssignal kann mittels der Signalspannungsgröße übertragen werden.

Der Leistungsstrom kann mittels des mindestens einen Packleistungskontakts und des mindestens einen Geräteleistungskontakts übertragen werden.

Der Leistungsstrom kann von Null verschieden und/oder zur Aufladung und/oder zur Entladung des Akkupacks, insbesondere zum Antrieb des Bearbeitungsgeräts, insbesondere eines Antriebsmotors des Bearbeitungsgeräts, sein.

Das Verfahren, insbesondere das Vergleichen, kann aufweisen: Bestimmen, insbesondere Messen, der Signalspannungsgröße und/oder der Leistungsspannungsgröße.

Die Signalspannungsgröße und die Leistungsspannungsgröße können verschieden sein.

Der/die Kontakt/e kann/können als Klemme/n bzw. Anschluss/Anschlüsse bzw. Terminal/s bezeichnet werden.

Die Berührung des mindestens einen Packleistungskontakts und des mindestens einen Geräteleistungskontakts kann, insbesondere werkzeugfrei und/oder zerstörungsfrei, lösbar sein. In anderen Worten: Der Akkupack kann zur, insbesondere werkzeugfrei und/oder zerstörungsfrei, lösbaren, insbesondere elektrischen und/oder mechanischen, Verbindung mit dem Bearbeitungsgerät und/oder dem Ladegerät ausgebildet sein. Insbesondere kann der Akkupack zum Tragen durch das Bearbeitungsgerät und/oder das Ladegerät ausgebildet sein. Insbesondere kann das Bearbeitungsgerät und/oder das Ladegerät, insbesondere jeweils, eine Akkuaufnahme, insbesondere einen Akkuschacht, aufweisen, wobei die Akkuaufnahme zum Aufnehmen des Akkupacks ausgebildet sein kann.

Das Bearbeitungsgerät kann ein Garten-, Forst-, Bau- und/oder Bodenbearbeitungsgerät, insbesondere eine Säge, insbesondere eine Kettensäge, ein Hoch-Entaster, ein Freischneider, eine Heckenschere, ein Heckenschneider, ein Blasgerät, ein Laubbläser, eine Astschere, ein Trennschleifer, ein Kehrgerät, eine Kehrwalze, eine Kehrbürste, ein Rasenmäher, ein Vertikutierer, eine Grasschere oder ein Hochdruckreiniger, sein. Zusätzlich oder alternativ kann das Bearbeitungsgerät boden- und/oder handgeführt, insbesondere handgetragen, sein. Insbesondere handgeführtes, insbesondere handgetragenes, Bearbeitungsgerät kann bedeuten, dass das Bearbeitungsgerät eine Masse von maximal 50 kg (Kilogramm), insbesondere maximal 20 kg, insbesondere maximal 10 kg, aufweisen bzw. haben kann.

Der Akkupack kann eine Mehrzahl von Akkumulatorzellen aufweisen. Insbesondere können die Akkumulatorzellen jeweils einzelne wiederaufladbare Speicherelemente für elektrische Energie auf elektrochemischer Basis sein. Zusätzlich oder alternativ können die Akkumulatorzellen Lithium-Ionen-Akkumulatorzellen sein. Weiter zusätzlich oder alternativ können die Akkumulatorzellen gleich, insbesondere typ- und/oder baugleich, sein. Weiter zusätzlich oder alternativ kann eine, insbesondere jeweilige, Zell-Spannung, insbesondere Zell-Nennspannung, einer, insbesondere jeweiligen, der Akkumulatorzellen minimal 2 V (Volt) und/oder maximal 4 V, insbesondere 3,6 V, sein. Weiter zusätzlich oder alternativ können die Akkumulatorzellen Rundzellen, prismatische Zellen oder Pouchzellen sein.

In einer Weiterbildung der Erfindung weist das Verfahren, insbesondere das Vergleichen, auf: Bestimmen des mindestens eines Leistungskontaktwiderstands oder des mindestens einen Widerstandswerts mittels Bestimmens, insbesondere automatischen und/oder unmittelbaren bzw. direkten Bestimmens und/oder Messens, des Leistungsstroms.

In einer Weiterbildung der Erfindung ist die Datenkommunikationsleitung von dem mindestens einen Packleistungskontakt und dem mindestens einen Geräteleistungskontakt verschieden bzw. getrennt, insbesondere elektrisch isoliert. Insbesondere umfasst bzw. weist der Akkupack einen von dem mindestens einen Packleistungskontakt verschiedenen bzw. getrennten, insbesondere elektrisch isolierten, insbesondere elektrischen, Packdatenkontakt auf. Das Bearbeitungsgerät oder das Ladegerät umfasst bzw. weist einen von dem mindestens einen Geräteleistungskontakt verschiedenen bzw. getrennten, insbesondere elektrisch isolierten, insbesondere elektrischen, Gerätedatenkontakt auf. Der Packdatenkontakt und der Gerätedatenkontakt berühren bzw. kontaktieren einander bzw. sich, insbesondere mechanisch und/oder elektrisch und/oder unmittelbar. Die Datenkommunikationsleitung ist mindestens teilweise, insbesondere vollständig, durch die Berührung des Packdatenkontakts und des Gerätedatenkontakts hergestellt bzw. gebildet. Dies ermöglicht, dass, insbesondere entweder, die Signalspannungsgröße oder die Leistungsspannungsgröße von dem mindestens einen Spannungsabfall abhängen kann. Insbesondere kann ein Strom und somit ein Spannungsabfall über die Datenkommunikationsleitung verursacht durch den Strom und einen Kontaktwiderstand zwischen dem Packdatenkontakt und dem Gerätedatenkontakt gegenüber dem Leistungsstrom und dem mindestens einen Leistungskontaktwiderstand vernachlässigbar, insbesondere niedrig, sein.

In einer Weiterbildung der Erfindung weist das Verfahren auf: Vergleichen mittels Ermittelns, insbesondere automatischen Ermittelns und/oder Bestimmens und/oder Messens und/oder Berechnens, einer Abweichung, insbesondere eines Werts der Abweichung und/oder einer Differenz, der Signalspannungsgröße und der Leistungsspannungsgröße voneinander.

In einer Weiterbildung der Erfindung ist die Leistungsspannungsgröße ein Leistungsspannungspotential, insbesondere ein Minus-Leistungsspannungspotential und/oder ein Plus-Leistungsspannungspotential, des Packleistungskontakts, insbesondere eines Minus-Packleistungskontakts und/oder eines Plus-Packleistungskontakts, und/oder eine Leistungsspannungsdifferenz zwischen dem Plus-Leistungsspannungspotential des Plus-Packleistungskontakts und dem Minus-Leistungsspannungspotential des Minus-Packleistungskontakts. Alternativ ist die Leistungsspannungsgröße ein Leistungsspannungspotential, insbesondere ein Minus-Leistungsspannungspotential und/oder ein Plus-Leistungsspannungspotential, des Geräteleistungskontakts, insbesondere eines Minus-Geräteleistungskontakts und/oder eines Plus-Geräteleistungskontakts, und/oder eine Leistungsspannungsdifferenz zwischen dem Plus-Leistungsspannungspotential des Plus-Geräteleistungskontakts und dem Minus-Leistungsspannungspotential des Minus-Geräteleistungskontakts. Eine derartige Leistungsspannungsgröße ist für das Vergleichen besonders geeignet, insbesondere vorteilhaft.

In einer Weiterbildung der Erfindung ist die Signalspannungsgröße ein Signalspannungspegel bzw. -potential, insbesondere ein niedriger Signalspannungspegel oder ein hoher Signalspannungspegel, der Datenkommunikationsleitung und/oder eine Signalspannungsdifferenz bzw. -amplitude bzw. ein Signalspannungshub zwischen dem hohen Signalspannungspegel und dem niedrigen Signalspannungspegel. Eine derartige Signalspannungsgröße ist für das Vergleichen besonders geeignet, insbesondere vorteilhaft. Insbesondere kann das Datenkommunikationssignal binär sein. Im Übrigen wird auf die Fachliteratur verwiesen.

In einer Ausgestaltung der Erfindung weist das Verfahren auf: Bestimmen eines, insbesondere ersten, Leistungskontaktwiderstands zwischen einem, insbesondere ersten, Packleistungskontakt des Akkupacks und einem, insbesondere ersten, Geräteleistungskontakt des Bearbeitungsgeräts oder des Ladegeräts oder eines dem Leistungskontaktwiderstand korrespondierenden, insbesondere ersten, Widerstandswerts mittels Vergleichens des Signalspannungspegels und des Leistungsspannungspotentials miteinander. Insbesondere entweder, der Signalspannungspegel oder das Leistungsspannungspotential hängt von einem, insbesondere ersten, Spannungsabfall verursacht durch den Leistungsstrom und den Leistungskontaktwiderstand ab. Zusätzlich oder alternativ, insbesondere zeitlich danach, Bestimmen eines, insbesondere zweiten und/oder anderen, Leistungskontaktwiderstands zwischen einem, insbesondere zweiten und/oder anderen, Packleistungskontakt des Akkupacks und einem, insbesondere zweiten und/oder anderen, Geräteleistungskontakt des Bearbeitungsgeräts oder des Ladegeräts oder eines dem Leistungskontaktwiderstand korrespondierenden, insbesondere zweiten und/oder anderen, Widerstandswerts mittels Vergleichens der Signalspannungsdifferenz und der Leistungsspannungsdifferenz miteinander. Insbesondere entweder, die Signalspannungsdifferenz oder die Leistungsspannungsdifferenz hängt von mindestens einem, insbesondere zweiten und/oder anderen, Spannungsabfall verursacht durch den Leistungsstrom und den mindestens einen Leistungskontaktwiderstand ab. Dies ermöglicht das Bestimmen eines Plus-Leistungskontaktwiderstands oder eines korrespondierenden Plus-Widerstandswerts und/oder eines Minus-Leistungskontaktwiderstands oder eines korrespondierenden Minus-Widerstandswerts, insbesondere jeweils, bzw. dieser verschiedenen Leistungskontaktwiderstände oder Widerstandswerte.

In einer Weiterbildung der Erfindung ist, insbesondere entweder, die Signalspannungsgröße auf ein Leistungsspannungspotential, insbesondere ein Minus-Leistungsspannungspotential und/oder ein Plus-Leistungsspannungspotential, des Geräteleistungskontakts, insbesondere eines Minus-Geräteleistungskontakts und/oder eines Plus-Geräteleistungskontakts, referenziert und/oder hängt von einer Leistungsspannungsdifferenz zwischen dem Plus-Leistungsspannungspotential des Plus-Geräteleistungskontakts und dem Minus-Leistungsspannungspotential des Minus-Geräteleistungskontakts ab. Alternativ bzw. oder ist die Signalspannungsgröße auf ein Leistungsspannungspotential, insbesondere ein Minus-Leistungsspannungspotential und/oder ein Plus-Leistungsspannungspotential, des Packleistungskontakts, insbesondere eines Minus-Packleistungskontakts und/oder eines Plus-Packleistungskontakts, referenziert und/oder hängt von einer Leistungsspannungsdifferenz zwischen dem Plus-Leistungsspannungspotential des Plus-Packleistungskontakts und dem Minus-Leistungsspannungspotential des Minus-Packleistungskontakts ab. Dies ermöglicht, dass, insbesondere entweder, die Signalspannungsgröße oder die Leistungsspannungsgröße von dem mindestens einen Spannungsabfall abhängen kann.

In einer Weiterbildung der Erfindung ist die Datenkommunikationsleitung mit einem Signalausgang eines, insbesondere elektrischen, Senders, insbesondere einer Verstärkerschaltung, insbesondere des Bearbeitungsgeräts oder des Ladegeräts oder des Akkupacks, elektrisch, insbesondere galvanisch, verbunden. Mindestens ein, insbesondere elektrisches, Versorgungsspannungspotential des Senders hängt von mindestens einem, insbesondere dem mindestens einen, Spannungsabfall verursacht durch den Leistungsstrom und den mindestens einen Leistungskontaktwiderstand ab. Insbesondere hat bzw. weist der Sender einen Versorgungsspannungsdurchgriff auf. Zusätzlich oder alternativ ist mindestens ein, insbesondere elektrisches, Versorgungsspannungspotential des Senders auf mindestens ein Leistungsspannungspotential des mindestens einen Geräteleistungskontakts oder mindestens ein Leistungsspannungspotential des mindestens einen Packleistungskontakts referenziert, insbesondere ist das mindestens eine Leistungsspannungspotential. Weiter zusätzlich oder alternativ ist mindestens ein Versorgungsspannungseingang des Senders mit dem mindestens einen Geräteleistungskontakt oder dem mindestens einen Packleistungskontakt elektrisch, insbesondere galvanisch, verbunden, insbesondere parallelgeschaltet. Dies ermöglicht, dass die Signalspannungsgröße von dem mindestens einen Spannungsabfall abhängen kann oder derartig wie vorhergehend genannt sein kann. Insbesondere kann die Datenkommunikationsleitung mit einem Signaleingang eines, insbesondere elektrischen, Empfängers, insbesondere des Akkupacks oder des Bearbeitungsgeräts oder des Ladegeräts, elektrisch, insbesondere galvanisch, verbunden sein. Zusätzlich oder alternativ kann das Datenkommunikationssignal mittels der Verstärkerschaltung verstärkt sein. Weiter zusätzlich oder alternativ kann die Verstärkerschaltung eine Operations- und/oder Differenzverstärkerschaltung aufweisen, insbesondere sein. Im Übrigen wird auf die Fachliteratur verwiesen.

In einer Weiterbildung der Erfindung umfasst bzw. weist das Datenkommunikationssignal eine Betriebsdaten-Information, eine Drehzahl-Information, eine Strom-Information, eine Spannungs-Information, eine Leistungs-Information, eine Entladungs-Information, eine Aufladungs-Information, eine Temperatur-Information, eine Zustands-Information, eine Fehler-Information und/oder eine Identifikator-Information auf. Eine derartige Information/en ist/sind für einen Betrieb und/oder eine Auswertung des Betriebs des Akkupacks, des Bearbeitungsgeräts und/oder des Ladegeräts geeignet, insbesondere vorteilhaft. Insbesondere können/kann die Drehzahl-Information über eine Drehzahl und/oder die Strom-Information über einen Motorstrom eines Antriebsmotors des Bearbeitungsgeräts sein. Zusätzlich oder alternativ kann die Temperatur-Information über eine Temperatur eines Antriebsmotors des Bearbeitungsgeräts und/oder von Akkumulatorzellen des Akkupacks sein. Weiter zusätzlich oder alternativ können/kann die Zustands-Information über einen Zustand, die Fehler-Information über einen Fehler und/oder die Identifikator-Information über einen Identifikator des Bearbeitungsgeräts und/oder des Akkupacks sein. Weiter zusätzlich oder alternativ kann die, insbesondere jeweilige, Information von der Signalspannungsgröße verschieden, insbesondere verschiedenartig, sein. Im Übrigen wird auf die Fachliteratur verwiesen.

In einer Weiterbildung der Erfindung sind/ist der mindestens eine Packleistungskontakt und/oder der mindestens eine Geräteleistungskontakt, insbesondere jeweils, ein Steckverbinder. Insbesondere kann der Steckverbinder ein Stecker oder eine, insbesondere korrespondierende, Buchse sein. Dies ermöglicht, dass der Leistungskontaktwiderstand nicht vernachlässigbar, insbesondere hoch, sein kann, und/oder die Lösbarkeit wie vorhergehend genannt.

In einer Weiterbildung der Erfindung ist eine, insbesondere elektrische, Nennspannung des Akkupacks, des Bearbeitungsgeräts und/oder des Ladegeräts minimal 18 V, insbesondere minimal 30 V, und/oder maximal 72 V, insbesondere maximal 54 V. Zusätzlich oder alternativ ist ein maximaler, insbesondere elektrischer, Leistungsstrom, insbesondere Aufladungs- und/oder Entladungs-Leistungsstrom, insbesondere Antriebs-Leistungsstrom, des Akkupacks, des Bearbeitungsgeräts und/oder des Ladegeräts minimal 1 A (Ampere), insbesondere minimal 1,5 A, und/oder maximal 1000 A, insbesondere maximal 750 A. Weiter zusätzlich oder alternativ ist eine maximale, insbesondere elektrische, Leistung des Akkupacks, des Bearbeitungsgeräts und/oder des Ladegeräts minimal 1 kW (Kilowatt), insbesondere minimal 2 kW, und/oder maximal 10 kW, insbesondere maximal 5 kW. Weiter zusätzlich oder alternativ ist ein maximaler, insbesondere elektrischer, Energieinhalt, insbesondere Nennenergieinhalt, des Akkupacks minimal 100 Wh (Wattstunden), insbesondere minimal 200 Wh, und/oder maximal 4000 Wh, insbesondere maximal 2000 Wh. Dies ermöglicht, dass der Leistungskontaktwiderstand nicht vernachlässigbar, insbesondere hoch, sein kann.

In einer Weiterbildung der Erfindung umfasst bzw. weist das Verfahren, insbesondere den Schritt, auf: Ausgeben, insbesondere automatisches Ausgeben, und/oder Übertragen, insbesondere automatisches Übertragen, einer, insbesondere benutzerwahrnehmbaren, Information über den mindestens einen bestimmten Leistungskontaktwiderstand oder den mindestens einen bestimmten Widerstandswert, insbesondere falls der mindestens eine bestimmte Leistungskontaktwiderstand oder der mindestens eine bestimmte Widerstandswert einen, insbesondere vorgegebenen, Widerstandsgrenzwert erreicht oder überschreitet. Zusätzlich oder alternativ, falls der mindestens eine bestimmte Leistungskontaktwiderstand oder der mindestens eine bestimmte Widerstandswert einen, insbesondere vorgegebenen, Widerstandsgrenzwert erreicht oder überschreitet, Absenken, insbesondere automatisches Absenken, einer maximal freigegebenen Leistung und/oder eines maximal freigegebenen Leistungsstroms, insbesondere Abschalten des Akkupacks, des Bearbeitungsgeräts und/oder des Ladegeräts. Dies ermöglicht einen Schutz, eine Reinigung, eine Wartung und/oder eine Reparatur des Akkupacks, des Bearbeitungsgeräts und/oder des Ladegeräts. Insbesondere kann die Information eine Schutz- Information, eine Reinigungs-Information, eine Wartungs-Information, eine Reparatur-Information und/oder eine Absenkungs-, insbesondere Abschaltungs-, Information aufweisen, insbesondere sein. Zusätzlich oder alternativ kann das Ausgeben optisch, akustisch und/oder haptisch sein. Weiter zusätzlich oder alternativ kann das Übertragen kabellos bzw. drahtlos sein und/oder ein Senden aufweisen, insbesondere sein.

Das erfindungsgemäße, insbesondere elektrische, System ist zum Bestimmen mindestens eines, insbesondere des mindestens einen, Leistungskontaktwiderstands zwischen mindestens einem, insbesondere dem mindestens einen, Packleistungskontakt eines, insbesondere des, Akkupacks und mindestens einem, insbesondere dem mindestens einen, Geräteleistungskontakt eines, insbesondere des, elektrisch angetriebenen Bearbeitungsgeräts oder eines, insbesondere des, Ladegeräts oder mindestens eines, insbesondere dem mindestens einen, dem mindestens einen Leistungskontaktwiderstand korrespondierenden Widerstandswerts ausgebildet bzw. konfiguriert. Der mindestens eine Packleistungskontakt und der mindestens eine Geräteleistungskontakt berühren einander und sind mit einem, insbesondere dem, Leistungsstrom belastet. Der Akkupack und das Bearbeitungsgerät oder das Ladegerät sind mittels einer, insbesondere der, Datenkommunikationsleitung zum Übertragen eines, insbesondere des, Datenkommunikationssignals elektrisch verbunden. Das System ist zum Bestimmen des mindestens einen Leistungskontaktwiderstands oder des mindestens einen Widerstandswerts mittels Vergleichens einer, insbesondere der, Signalspannungsgröße der Datenkommunikationsleitung und einer, insbesondere der, Leistungsspannungsgröße des mindestens einen Packleistungskontakts oder des mindestens einen Geräteleistungskontakts miteinander ausgebildet bzw. konfiguriert. Die Signalspannungsgröße oder die Leistungsspannungsgröße hängt von mindestens einem, insbesondere dem mindestens einen, Spannungsabfall verursacht durch den Leistungsstrom und den mindestens einen Leistungskontaktwiderstand ab.

Das System kann den/die gleichen Vorteil/e ermöglichen wie für das Verfahren vorhergehend genannt.

Insbesondere kann das System, insbesondere ein Batteriemanagementsystem des Systems, zum, insbesondere automatischen, Ausführen eines, insbesondere des, Verfahrens wie vorhergehend genannt ausgebildet bzw. konfiguriert sein.

In einer Weiterbildung der Erfindung umfasst bzw. weist das System den Akkupack, das Bearbeitungsgerät und/oder das Ladegerät auf. insbesondere kann der Akkupack, das Bearbeitungsgerät und/oder das Ladegerät, insbesondere jeweils, ein, insbesondere das, Batteriemanagementsystem aufweisen bzw. umfassen.

### KURZBESCHREIBUNG DER ZEICHNUNGEN

Weitere Vorteile und Aspekte der Erfindung ergeben sich aus den Ansprüchen und aus der Beschreibung von Ausführungsbeispielen der Erfindung, die nachfolgenden anhand der Figuren erläutert sind. Dabei zeigen:
- Fig. 1 bis 4: schematische Ansichten, insbesondere Schaltpläne, insbesondere jeweils, eines erfindungsgemäßen Systems und eines erfindungsgemäßen Verfahrens, und
- Fig. 5: eine Perspektivansicht des Systems der Fig. 1 und 2.

### DETAILLIERTE BESCHREIBUNG DER AUSFÜHRUNGSBEISPIELE

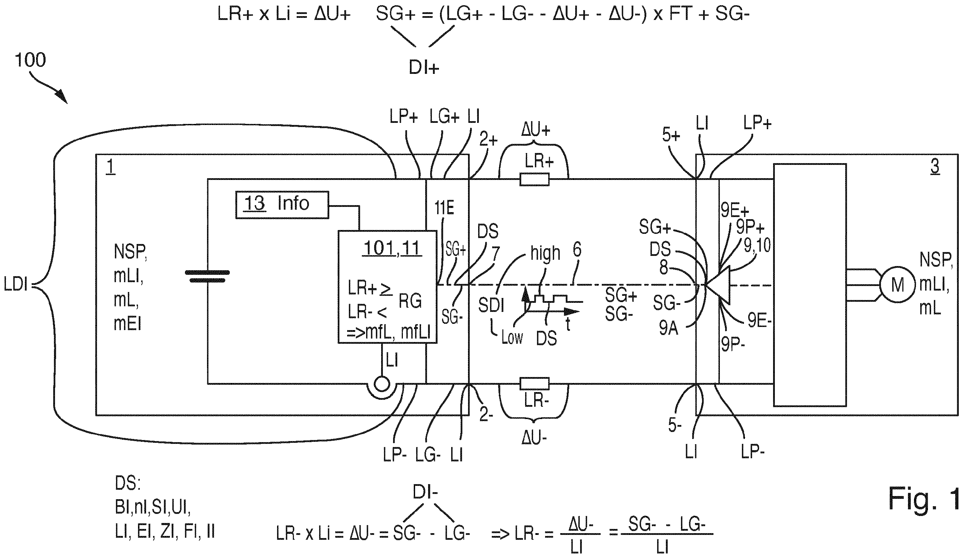

Fig. 1 bis 4 und 5 zeigen, insbesondere jeweils, ein erfindungsgemäßes System 100 und ein erfindungsgemäßes Verfahren zum Bestimmen mindestens eines Leistungskontaktwiderstands LR+, LR- zwischen mindestens einem Packleistungskontakt 2+, 2- eines Akkupacks 1 und mindestens einem Geräteleistungskontakt 5+, 5- eines elektrisch angetriebenen Bearbeitungsgeräts 3 oder eines Ladegeräts 4 oder mindestens eines dem mindestens einen Leistungskontaktwiderstand korrespondierenden Widerstandswerts. Der mindestens eine Packleistungskontakt 2+, 2- und der mindestens eine Geräteleistungskontakt 5+, 5- berühren einander und sind mit einem Leistungsstrom LI belastet. Der Akkupack 1 und das Bearbeitungsgerät 3 oder das Ladegerät 4 sind mittels, insbesondere nur, einer, insbesondere einzigen, Datenkommunikationsleitung 6 zum Übertragen eines Datenkommunikationssignals DS elektrisch verbunden, insbesondere übertragen.

Das System 100, insbesondere ein Batteriemanagementsystem 101 des Systems 100, ist zum Bestimmen des mindestens einen Leistungskontaktwiderstands LR+, LR- oder des mindestens einen Widerstandswerts mittels Vergleichens einer Signalspannungsgröße SG+, SG- der Datenkommunikationsleitung 6 und einer Leistungsspannungsgröße LG+, LG- des mindestens einen Packleistungskontakts 2+, 2- oder des mindestens einen Geräteleistungskontakts 5+, 5-miteinander ausgebildet, insbesondere vergleicht und bestimmt.

Das Verfahren weist auf: Bestimmen des mindestens einen Leistungskontaktwiderstands LR+, LR- oder des mindestens einen Widerstandswerts mittels Vergleichens der Signalspannungsgröße SG+, SG- der Datenkommunikationsleitung 6 und der Leistungsspannungsgröße LG+, LG- des mindestens einen Packleistungskontakts 2+, 2- oder des mindestens einen Geräteleistungskontakts 5+, 5- miteinander, insbesondere mittels des Systems 100, insbesondere des Batteriemanagementsystems 101.

Die Signalspannungsgröße SG+, SG- oder die Leistungsspannungsgröße LG+, LG- hängt von mindestens einem Spannungsabfall ΔU+, ΔU- verursacht durch den Leistungsstrom LI und den mindestens einen Leistungskontaktwiderstand LR+, LR- ab.

Im Detail weist das Verfahren auf: Bestimmen des mindestens eines Leistungskontaktwiderstands LR+, LR- oder des mindestens einen Widerstandswerts mittels Bestimmens des Leistungsstroms LI, insbesondere mittels des Systems 100, insbesondere des Batteriemanagementsystems 101.

Des Weiteren weist in den gezeigten Ausführungsbeispielen das Verfahren auf: Bestimmen der Signalspannungsgröße SG+, SG- und/oder der Leistungsspannungsgröße LG+, LG-, insbesondere mittels des Systems 100, insbesondere des Batteriemanagementsystems 101.

Außerdem weist das System 100 den Akkupack 1, das Bearbeitungsgerät 3 und/oder das Ladegerät 4 auf.

In Fig. 1 weist der Akkupack 1 das Batteriemanagementsystem 101 auf.

Weiter wird ein Minus-Leistungskontaktwiderstand LR- zwischen einem Minus-Packleistungskontakt 2- des Akkupacks 1 und einem Minus-Geräteleistungskontakt 5- des Bearbeitungsgeräts 3 mittels Vergleichens einer Minus-Signalspannungsgröße SG- der Datenkommunikationsleitung 6 und einer Minus-Leistungsspannungsgröße LG- des Minus-Packleistungskontakts 2- bestimmt, insbesondere mittels des Systems 100, insbesondere des Batteriemanagementsystems 101. Der Minus-Packleistungskontakt 2- und der Minus-Geräteleistungskontakt 5- berühren einander und sind mit dem Leistungsstrom LI belastet. Die Minus-Signalspannungsgröße SG- hängt von einem Minus-Spannungsabfall ΔU- verursacht durch den Leistungsstrom LI und den Minus-Leistungskontaktwiderstand LR- ab.

Zudem wird ein Plus-Leistungskontaktwiderstand LR+ zwischen einem Plus-Packleistungskontakt 2+ des Akkupacks 1 und einem Plus-Geräteleistungskontakt 5+ des Bearbeitungsgeräts 3 mittels Vergleichens einer Plus-Signalspannungsgröße SG+ der Datenkommunikationsleitung 6 und einer Plus-Leistungsspannungsgröße LG+ des Plus-Packleistungskontakts 2+ bestimmt, insbesondere mittels des Systems 100, insbesondere des Batteriemanagementsystems 101. Der Plus-Packleistungskontakt 2+ und der Plus-Geräteleistungskontakt 5+ berühren einander und sind mit dem Leistungsstrom LI belastet. Die Plus-Signalspannungsgröße SG+ hängt von dem Minus-Spannungsabfall ΔU- verursacht durch den Leistungsstrom LI und den Minus-Leistungskontaktwiderstand LR- und einem Plus-Spannungsabfall ΔU+ verursacht durch den Leistungsstrom LI und den Plus-Leistungskontaktwiderstand LR+ ab.

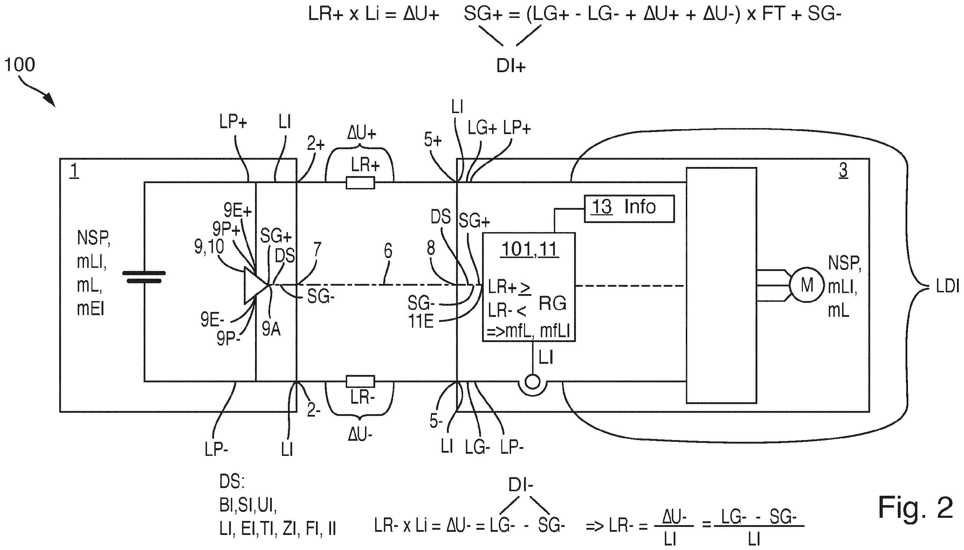

In Fig. 2 weist das Bearbeitungsgerät 3 das Batteriemanagementsystem 101 auf.

Des Weiteren wird der Minus-Leistungskontaktwiderstand LR- zwischen dem Minus-Packleistungskontakt 2- des Akkupacks 1 und dem Minus-Geräteleistungskontakt 5- des Bearbeitungsgeräts 3 mittels Vergleichens einer Minus-Signalspannungsgröße SG- der Datenkommunikationsleitung 6 und einer Minus-Leistungsspannungsgröße LG- des Minus-Geräteleistungskontakts 5- bestimmt, insbesondere mittels des Systems 100, insbesondere des Batteriemanagementsystems 101. Der Minus-Packleistungskontakt 2- und der Minus-Geräteleistungskontakt 5- berühren einander und sind mit dem Leistungsstrom LI belastet. Die Minus-Leistungsspannungsgröße LG- hängt von dem Minus-Spannungsabfall ΔU- verursacht durch den Leistungsstrom LI und den Minus-Leistungskontaktwiderstand LR- ab.

Außerdem wird der Plus-Leistungskontaktwiderstand LR+ zwischen dem Plus-Packleistungskontakt 2+ des Akkupacks 1 und dem Plus-Geräteleistungskontakt 5+ des Bearbeitungsgeräts 3 mittels Vergleichens einer Plus-Signalspannungsgröße SG+ der Datenkommunikationsleitung 6 und einer Plus-Leistungsspannungsgröße LG+ des Plus-Geräteleistungskontakts 5+ bestimmt, insbesondere mittels des Systems 100, insbesondere des Batteriemanagementsystems 101. Der Plus-Packleistungskontakt 2+ und der Plus-Geräteleistungskontakt 5+ berühren einander und sind mit dem Leistungsstrom LI belastet. Die Plus-Leistungsspannungsgröße LG+ hängt von dem Minus-Spannungsabfall ΔU- verursacht durch den Leistungsstrom LI und den Minus-Leistungskontaktwiderstand LR- und dem Plus-Spannungsabfall ΔU+ verursacht durch den Leistungsstrom LI und den Plus-Leistungskontaktwiderstand LR+ ab.

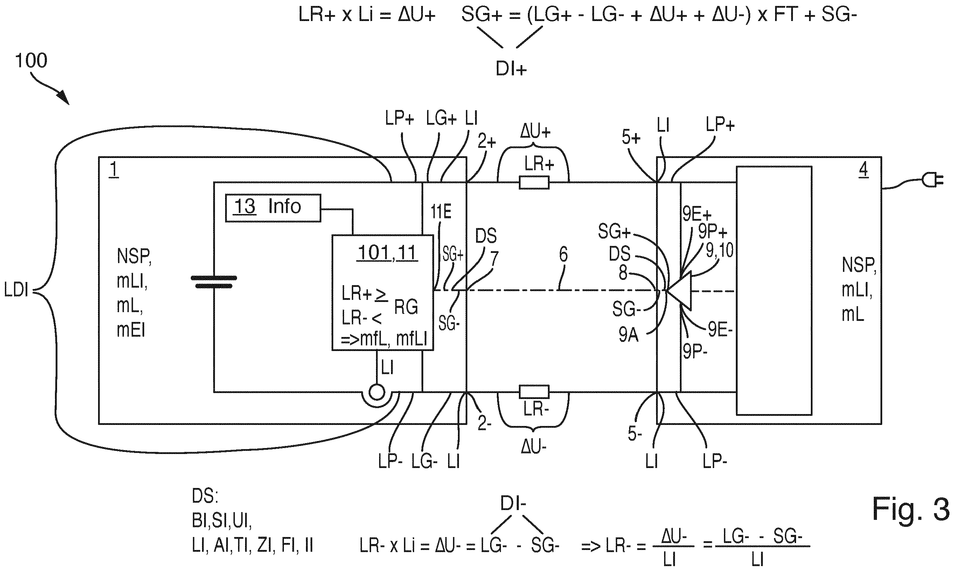

In Fig. 3 weist der Akkupack 1 das Batteriemanagementsystem 101 auf.

Weiter wird ein Minus-Leistungskontaktwiderstand LR- zwischen dem Minus-Packleistungskontakt 2- des Akkupacks 1 und einem Minus-Geräteleistungskontakt 5- des Ladegeräts 4 mittels Vergleichens einer Minus-Signalspannungsgröße SG- der Datenkommunikationsleitung 6 und einer Minus-Leistungsspannungsgröße LG- des Minus-Packleistungskontakts 2- bestimmt, insbesondere mittels des Systems 100, insbesondere des Batteriemanagementsystems 101. Der Minus-Packleistungskontakt 2- und der Minus-Geräteleistungskontakt 5- berühren einander und sind mit dem Leistungsstrom LI belastet. Die Minus-Leistungsspannungsgröße LG- hängt von einem Minus-Spannungsabfall ΔU- verursacht durch den Leistungsstrom LI und den Minus-Leistungskontaktwiderstand LR- ab.

Zudem wird ein Plus-Leistungskontaktwiderstand LR+ zwischen dem Plus-Packleistungskontakt 2+ des Akkupacks 1 und einem Plus-Geräteleistungskontakt 5+ des Ladegeräts 4 mittels Vergleichens einer Plus-Signalspannungsgröße SG+ der Datenkommunikationsleitung 6 und einer Plus-Leistungsspannungsgröße LG+ des Plus-Packleistungskontakts 2+ bestimmt, insbesondere mittels des Systems 100, insbesondere des Batteriemanagementsystems 101. Der Plus-Packleistungskontakt 2+ und der Plus-Geräteleistungskontakt 5+ berühren einander und sind mit dem Leistungsstrom LI belastet. Die Plus-Leistungsspannungsgröße LG+ hängt von dem Minus-Spannungsabfall ΔU- verursacht durch den Leistungsstrom LI und den Minus-Leistungskontaktwiderstand LR- und einem Plus-Spannungsabfall ΔU+ verursacht durch den Leistungsstrom LI und den Plus-Leistungskontaktwiderstand LR+ ab.

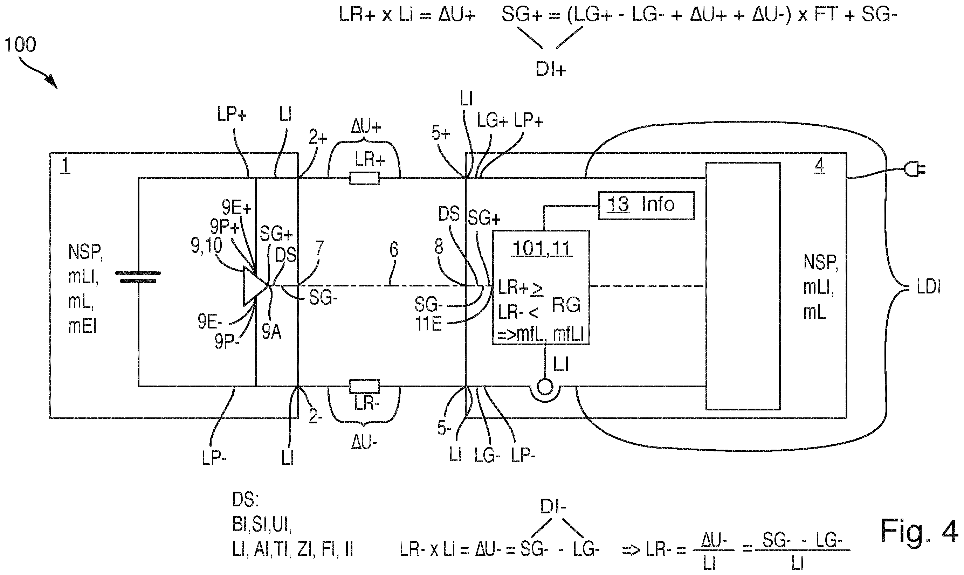

In Fig. 4 weist das Ladegerät 4 das Batteriemanagementsystem 101 auf.

Des Weiteren wird der Minus-Leistungskontaktwiderstand LR- zwischen dem Minus-Packleistungskontakt 2- des Akkupacks 1 und dem Minus-Geräteleistungskontakt 5- des Ladegeräts 4 mittels Vergleichens einer Minus-Signalspannungsgröße SG- der Datenkommunikationsleitung 6 und einer Minus-Leistungsspannungsgröße LG- des Minus-Geräteleistungskontakts 5- bestimmt, insbesondere mittels des Systems 100, insbesondere des Batteriemanagementsystems 101. Der Minus-Packleistungskontakt 2- und der Minus-Geräteleistungskontakt 5- berühren einander und sind mit dem Leistungsstrom LI belastet. Die Minus-Signalspannungsgröße SG- hängt von dem Minus-Spannungsabfall ΔU- verursacht durch den Leistungsstrom LI und den Minus-Leistungskontaktwiderstand LR- ab.

Außerdem wird der Plus-Leistungskontaktwiderstand LR+ zwischen dem Plus-Packleistungskontakt 2+ des Akkupacks 1 und dem Plus-Geräteleistungskontakt 5+ des Ladegeräts 4 mittels Vergleichens einer Plus-Signalspannungsgröße SG+ der Datenkommunikationsleitung 6 und einer Plus-Leistungsspannungsgröße LG+ des Plus-Geräteleistungskontakts 5+ bestimmt, insbesondere mittels des Systems 100, insbesondere des Batteriemanagementsystems 101. Der Plus-Packleistungskontakt 2+ und der Plus-Geräteleistungskontakt 5+ berühren einander und sind mit dem Leistungsstrom LI belastet. Die Plus-Signalspannungsgröße SG+ hängt von dem Minus-Spannungsabfall ΔU- verursacht durch den Leistungsstrom LI und den Minus-Leistungskontaktwiderstand LR- und dem Plus-Spannungsabfall ΔU+ verursacht durch den Leistungsstrom LI und den Plus-Leistungskontaktwiderstand LR+ ab.

In alternativen Ausführungsbeispielen kann eine Summe eines, insbesondere des, Minus-Leistungskontaktwiderstands und eines, insbesondere des, Plus-Leistungskontaktwiderstands bestimmt werden. Zusätzlich oder alternativ können/kann in alternativen Ausführungsbeispielen eine, insbesondere die, Minus-Signalspannungsgröße und/oder eine, insbesondere die, Plus-Signalspannungsgröße und/oder eine, insbesondere die, Minus-Leistungsspannungsgröße und/oder eine, insbesondere die, Plus-Leistungsspannungsgröße von einem, insbesondere dem, Minus-Spannungsabfall verursacht durch den Leistungsstrom und den Minus-Leistungskontaktwiderstand und/oder einem, insbesondere dem, Plus-Spannungsabfall verursacht durch den Leistungsstrom und den Plus-Leistungskontaktwiderstand abhängen.

Weiter ist in den gezeigten Ausführungsbeispielen die Datenkommunikationsleitung 6 von dem mindestens einen Packleistungskontakt 2+, 2- und dem mindestens einen Geräteleistungskontakt 5+, 5- verschieden. Insbesondere weist der Akkupack 1, insbesondere nur, einen, insbesondere einzigen, von dem mindestens einen Packleistungskontakt 2+, 2-verschiedenen Packdatenkontakt 7 auf. Das Bearbeitungsgerät 3 oder das Ladegerät 4 weist, insbesondere nur, einen, insbesondere einzigen, von dem mindestens einen Geräteleistungskontakt 5+, 5- verschiedenen Gerätedatenkontakt 8 auf. Der Packdatenkontakt 7 und der Gerätedatenkontakt 8 berühren einander. Die Datenkommunikationsleitung 6 ist mindestens teilweise durch die Berührung des Packdatenkontakts 7 und des Gerätedatenkontakts 8 hergestellt.

Zudem weist das Verfahren auf: Vergleichen mittels Ermittelns einer Abweichung DI-, DI+, insbesondere einer Differenz DI-, DI+, der Signalspannungsgröße SG+, SG- und der Leistungsspannungsgröße LG+, LG- voneinander, insbesondere mittels des Systems 100, insbesondere des Batteriemanagementsystems 101.

In Fig. 1 und 3 ist die Minus-Leistungsspannungsgröße LG- ein Minus-Leistungsspannungspotential LP- des Minus-Packleistungskontakts 2-. Die Plus-Leistungsspannungsgröße LG+ ist ein Plus-Leistungsspannungspotential LP+ des Plus-Packleistungskontakts 2+ und/oder eine Leistungsspannungsdifferenz LDI zwischen dem Plus-Leistungsspannungspotential LP+ des Plus-Packleistungskontakts 2+ und dem Minus-Leistungsspannungspotential LP- des Minus-Packleistungskontakts 2-.

In Fig. 2 und 4 ist die Minus-Leistungsspannungsgröße LG- ein Minus-Leistungsspannungspotential LP- des Minus-Geräteleistungskontakts 5-. Die Plus-Leistungsspannungsgröße LG+ ist ein Plus-Leistungsspannungspotential LP+ des Plus-Geräteleistungskontakts 5+ und/oder eine Leistungsspannungsdifferenz LDI zwischen dem Plus-Leistungsspannungspotential LP+ des Plus-Geräteleistungskontakts 5+ und dem Minus-Leistungsspannungspotential LP- des Minus-Geräteleistungskontakts 5-.

Des Weiteren ist in den gezeigten Ausführungsbeispielen die Minus-Signalspannungsgröße SG- ein niedriger Signalspannungspegel low der Datenkommunikationsleitung 6. Die Plus-Signalspannungsgröße SG+ ist ein hoher Signalspannungspegel high der Datenkommunikationsleitung 6 und/oder eine Signalspannungsdifferenz SDI zwischen dem hohen Signalspannungspegel high und dem niedrigen Signalspannungspegel low.

In Fig. 1 und 2 weist das Verfahren auf: Bestimmen des Minus-Leistungskontaktwiderstands LR- zwischen dem Minus-Packleistungskontakt 2- des Akkupacks 1 und dem Minus-Geräteleistungskontakt 5- des Bearbeitungsgeräts 3 mittels Vergleichens des Minus-Signalspannungspegels low und des Minus-Leistungsspannungspotentials LP- miteinander. In Fig. 1 hängt der Minus-Signalspannungspegel low von dem Minus-Spannungsabfall ΔUverursacht durch den Leistungsstrom LI und den Minus-Leistungskontaktwiderstand LR- ab. In Fig. 2 hängt das Minus-Leistungsspannungspotential LP- von dem Minus-Spannungsabfall ΔUverursacht durch den Leistungsstrom LI und den Minus-Leistungskontaktwiderstand LR- ab.

Außerdem weist das Verfahren auf: Bestimmen des Plus-Leistungskontaktwiderstands LR+ zwischen dem Plus-Packleistungskontakt 2+ des Akkupacks 1 und dem Plus-Geräteleistungskontakt 5+ des Bearbeitungsgeräts 3 mittels Vergleichens der Signalspannungsdifferenz SDI und der Leistungsspannungsdifferenz LDI miteinander. In Fig. 1 hängt die Signalspannungsdifferenz SDI von dem Minus-Spannungsabfall ΔU- verursacht durch den Leistungsstrom LI und den Minus-Leistungskontaktwiderstand LR- und dem Plus-Spannungsabfall ΔU+ verursacht durch den Leistungsstrom LI und den Plus-Leistungskontaktwiderstand LR+ ab. In Fig. 2 hängt die Leistungsspannungsdifferenz LDI von dem Minus-Spannungsabfall ΔU- verursacht durch den Leistungsstrom LI und den Minus-Leistungskontaktwiderstand LR- und dem Plus-Spannungsabfall ΔU+ verursacht durch den Leistungsstrom LI und den Plus-Leistungskontaktwiderstand LR+ ab.

In Fig. 3 und 4 weist das Verfahren auf: Bestimmen des Minus-Leistungskontaktwiderstands LR- zwischen dem Minus-Packleistungskontakt 2- des Akkupacks 1 und dem Minus-Geräteleistungskontakt 5- des Ladegeräts 4 mittels Vergleichens des Minus-Signalspannungspegels low und des Minus-Leistungsspannungspotentials LP- miteinander. In Fig. 3 hängt das Minus-Leistungsspannungspotential LP- von dem Minus-Spannungsabfall ΔUverursacht durch den Leistungsstrom LI und den Minus-Leistungskontaktwiderstand LR- ab. In Fig. 4 hängt der Minus-Signalspannungspegel low von dem Minus-Spannungsabfall ΔUverursacht durch den Leistungsstrom LI und den Minus-Leistungskontaktwiderstand LR- ab.

Weiter weist das Verfahren auf: Bestimmen des Plus-Leistungskontaktwiderstands LR+ zwischen dem Plus-Packleistungskontakt 2+ des Akkupacks 1 und dem Plus-Geräteleistungskontakt 5+ des Ladegeräts 4 mittels Vergleichens der Signalspannungsdifferenz SDI und der Leistungsspannungsdifferenz LDI miteinander. In Fig. 3 hängt die Leistungsspannungsdifferenz LDI von dem Minus-Spannungsabfall ΔU- verursacht durch den Leistungsstrom LI und den Minus-Leistungskontaktwiderstand LR- und dem Plus-Spannungsabfall ΔU+ verursacht durch den Leistungsstrom LI und den Plus-Leistungskontaktwiderstand LR+ ab. In Fig. 4 hängt die Signalspannungsdifferenz SDI von dem Minus-Spannungsabfall ΔU- verursacht durch den Leistungsstrom LI und den Minus-Leistungskontaktwiderstand LR- und dem Plus-Spannungsabfall ΔU+ verursacht durch den Leistungsstrom LI und den Plus-Leistungskontaktwiderstand LR+ ab.

In Fig. 1 und 3 ist die Minus-Signalspannungsgröße SG- auf das Minus-Leistungsspannungspotential LP- des Minus-Geräteleistungskontakts 5- referenziert. Die Plus-Signalspannungsgröße SG+ ist auf das Minus-Leistungsspannungspotential LP- des Minus-Geräteleistungskontakts 5- referenziert und/oder hängt von der Leistungsspannungsdifferenz LDI zwischen dem Plus-Leistungsspannungspotential LP+ des Plus-Geräteleistungskontakts 5+ und dem Minus-Leistungsspannungspotential LP- des Minus-Geräteleistungskontakts 5- ab.

In Fig. 2 und 4 ist die Minus-Signalspannungsgröße SG- auf das Minus-Leistungsspannungspotential LP- des Minus-Packleistungskontakts 2- referenziert. Die Plus-Signalspannungsgröße SG+ ist auf das Minus-Leistungsspannungspotential LP- des Minus-Packleistungskontakts 2- referenziert und/oder hängt von der Leistungsspannungsdifferenz LDI zwischen dem Plus-Leistungsspannungspotential LP+ des Plus-Packleistungskontakts 2+ und dem Minus-Leistungsspannungspotential LP- des Minus-Packleistungskontakts 2- ab.

In alternativen Ausführungsbeispielen kann die Signalspannungsgröße auf das Plus-Leistungsspannungspotential des Plus-Geräteleistungskontakts oder des Plus-Packleistungskontakts referenziert sein.

Zudem ist in den gezeigten Ausführungsbeispielen die Datenkommunikationsleitung 6 mit einem Signalausgang 9A eines Senders 9, insbesondere einer Verstärkerschaltung 10, in Fig. 1 des Bearbeitungsgeräts 3, in Fig. 3 des Ladegeräts 4 und in Fig. 2 und 4 des Akkupacks 2, elektrisch verbunden.

In Fig. 1 und 4 hängt ein Minus-Versorgungsspannungspotential 9P- des Senders 9 von dem Minus-Spannungsabfall ΔU- verursacht durch den Leistungsstrom LI und den Minus-Leistungskontaktwiderstand LR- ab. Ein Plus-Versorgungsspannungspotential 9P+ des Senders 9 hängt von dem Minus-Spannungsabfall ΔU- verursacht durch den Leistungsstrom LI und den Minus-Leistungskontaktwiderstand LR- und dem Plus-Spannungsabfall ΔU+ verursacht durch den Leistungsstrom LI und den Plus-Leistungskontaktwiderstand LR+ ab.

Insbesondere weist der Sender 9 einen Versorgungsspannungsdurchgriff auf.

Zusätzlich oder alternativ ist in Fig. 1 und 3 das Minus-Versorgungsspannungspotential 9P- des Senders 9 auf das Minus-Leistungsspannungspotential LP- des Minus-Geräteleistungskontakts 5- referenziert, insbesondere ist das Minus-Leistungsspannungspotential LP-. Das Plus-Versorgungsspannungspotential 9P+ des Senders 9 ist auf das Plus-Leistungsspannungspotential LP+ des Plus-Geräteleistungskontakts 5+ referenziert, insbesondere ist das Plus-Leistungsspannungspotential LP+.

In Fig. 2 und 4 ist das Minus-Versorgungsspannungspotential 9P- des Senders 9 auf das Minus-Leistungsspannungspotential LP- des Minus-Packleistungskontakts 2- referenziert, insbesondere ist das Minus-Leistungsspannungspotential LP-. Das Plus-Versorgungsspannungspotential 9P+ des Senders 9 ist auf das Plus-Leistungsspannungspotential LP+ des Plus-Packleistungskontakts 2+ referenziert, insbesondere ist das Plus-Leistungsspannungspotential LP+.

Weiter zusätzlich oder alternativ ist in Fig. 1 und 3 ein Minus-Versorgungsspannungseingang 9E- des Senders 9 mit dem Minus-Geräteleistungskontakt 5- elektrisch verbunden, insbesondere parallelgeschaltet. Ein Plus-Versorgungsspannungseingang 9E+ des Senders 9 ist mit dem Plus-Geräteleistungskontakt 5+ elektrisch verbunden, insbesondere parallelgeschaltet.

In Fig. 2 und 4 ist der Minus-Versorgungsspannungseingang 9E- des Senders 9 mit dem Minus-Packleistungskontakt 2- elektrisch verbunden, insbesondere parallelgeschaltet. Der Plus-Versorgungsspannungseingang 9E+ des Senders 9 ist mit dem Plus-Packleistungskontakt 2+ elektrisch verbunden, insbesondere parallelgeschaltet.

Außerdem ist die Datenkommunikationsleitung 6 mit einem Signaleingang 11 E eines Empfängers 11, in Fig. 1 und 3 des Akkupacks 2, in Fig. 2 des Bearbeitungsgeräts 3 und in Fig. 4 des Ladegeräts 4, insbesondere des Batteriemanagementsystems 101, elektrisch verbunden.

Weiter weist das Datenkommunikationssignal DS eine Betriebsdaten-Information BI, eine Drehzahl-Information nl, eine Strom-Information SI, eine Spannungs-Information Ul, eine Leistungs-Information LI, eine Entladungs-Information EI, eine Aufladungs-Information Al, eine Temperatur-Information TI, eine Zustands-Information ZI, eine Fehler-Information FI und/oder eine Identifikator-Information II auf.

Zudem sind/ist der mindestens eine Packleistungskontakt 2+, 2- und/oder der mindestens eine Geräteleistungskontakt 5+, 5- ein Steckverbinder 12.

Des Weiteren ist eine Nennspannung NSP des Akkupacks 1, des Bearbeitungsgeräts 3 und/oder des Ladegeräts 4 minimal 18 V, insbesondere minimal 30 V, und/oder maximal 72 V, insbesondere maximal 54 V.

Zusätzlich oder alternativ ist ein maximaler Leistungsstrom mLI des Akkupacks 1, des Bearbeitungsgeräts 3 und/oder des Ladegeräts 4 minimal 1 A, insbesondere minimal 1,5 A, und/oder maximal 1000 A, insbesondere maximal 750 A.

Weiter zusätzlich oder alternativ ist eine maximale Leistung mL des Akkupacks 1, des Bearbeitungsgeräts 3 und/oder des Ladegeräts 4 minimal 1 kW, insbesondere minimal 2 kW, und/oder maximal 10 kW, insbesondere maximal 5 kW.

Weiter zusätzlich oder alternativ ist ein maximaler Energieinhalt mEI des Akkupacks 1 minimal 100 Wh, insbesondere minimal 200 Wh, und/oder maximal 4000 Wh, insbesondere maximal 2000 Wh.

Außerdem weist das System 100, in Fig. 1 und 3 der Akkupack 1, in Fig. 2 das Bearbeitungsgerät 3 und in Fig. 4 das Ladegerät 4, eine, insbesondere elektrische, Ausgabe- und/oder Übertragungseinrichtung 13 auf.

Insbesondere kann die Ausgabe- und/oder Übertragungseinrichtung eine Anzeige, einen Schallerzeuger und/oder eine Vibrationseinrichtung aufweisen. Zusätzlich oder alternativ kann die Ausgabe- und/oder Übertragungseinrichtung eine, insbesondere elektrische und/oder kabellose, Sendeeinrichtung aufweisen. Insbesondere kann die Sendeeinrichtung eine UMTS-, WLAN-, und/oder Bluetooth-Sendeeinrichtung oder eine auf einer anderen Technik basierende Sendeeinrichtung aufweisen, insbesondere sein.

Weiter weist das Verfahren auf: Ausgeben und/oder Übertragen einer Information Info über den mindestens einen bestimmten Leistungskontaktwiderstand LR+, LR- oder den mindestens einen bestimmten Widerstandswert, insbesondere falls der mindestens eine bestimmte Leistungskontaktwiderstand LR+, LR- oder der mindestens eine bestimmte Widerstandswert einen Widerstandsgrenzwert RG erreicht oder überschreitet, insbesondere mittels der Ausgabe- und/oder Übertragungseinrichtung 13.

Zusätzlich oder alternativ, falls der mindestens eine bestimmte Leistungskontaktwiderstand LR+, LR- oder der mindestens eine bestimmte Widerstandswert den Widerstandsgrenzwert RG erreicht oder überschreitet, Absenken einer maximal freigegebenen Leistung mfL und/oder eines maximal freigegebenen Leistungsstroms mfLI, insbesondere Abschalten des Akkupacks 1, des Bearbeitungsgeräts 3 und/oder des Ladegeräts 4, insbesondere mittels des Batteriemanagementsystems 101.

In den gezeigten Ausführungsbeispielen sind das Batteriemanagementsystem 101 und die Ausgabe- und/oder Übertragungseinrichtung 13 signalverbunden.

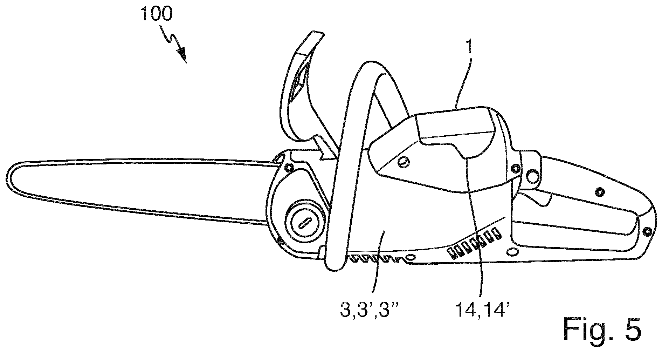

Zudem ist in Fig. 5 das Bearbeitungsgerät 3 eine Säge 3`, insbesondere eine Kettensäge 3".

In alternativen Ausführungsbeispielen kann das Bearbeitungsgerät ein Hoch-Entaster, ein Freischneider, eine Heckenschere, ein Heckenschneider, ein Blasgerät, ein Laubbläser, eine Astschere, ein Trennschleifer, ein Kehrgerät, eine Kehrwalze, eine Kehrbürste, ein Rasenmäher, ein Vertikutierer, eine Grasschere oder ein Hochdruckreiniger sein.

Im Übrigen weist das Bearbeitungsgerät 3 und/oder das Ladegerät 4 eine Akkuaufnahme 14, insbesondere einen Akkuschacht 14', auf. Die Akkuaufnahme 14 ist zum Aufnehmen des Akkupacks 1 ausgebildet, insbesondere ist der Akkupack 1 aufgenommen.

Wie die gezeigten und oben erläuterten Ausführungsbeispiele deutlich machen, stellt die Erfindung ein vorteilhaftes Verfahren und ein vorteilhaftes System jeweils zum Bestimmen mindestens eines Leistungskontaktwiderstands zwischen mindestens einem Packleistungskontakt eines Akkupacks und mindestens einem Geräteleistungskontakt eines elektrisch angetriebenen Bearbeitungsgeräts oder eines Ladegeräts oder mindestens eines dem mindestens einen Leistungskontaktwiderstand korrespondierenden Widerstandswerts bereit, das jeweils verbesserte Eigenschaften aufweist.

## Patentansprüche

1. Verfahren zum Bestimmen mindestens eines Leistungskontaktwiderstands (LR+, LR-) zwischen mindestens einem Packleistungskontakt (2+, 2-) eines Akkupacks (1) und mindestens einem Geräteleistungskontakt (5+, 5-) eines elektrisch angetriebenen Bearbeitungsgeräts (3) oder eines Ladegeräts (4) oder mindestens eines dem mindestens einen Leistungskontaktwiderstand korrespondierenden Widerstandswerts,
- wobei der mindestens eine Packleistungskontakt (2+, 2-) und der mindestens eine Geräteleistungskontakt (5+, 5-) einander berühren und mit einem Leistungsstrom (LI) belastet sind, und
- wobei der Akkupack (1) und das Bearbeitungsgerät (3) oder das Ladegerät (4) mittels einer Datenkommunikationsleitung (6) zum Übertragen eines Datenkommunikationssignals (DS) elektrisch verbunden sind,
- wobei das Verfahren aufweist: Bestimmen des mindestens einen Leistungskontaktwiderstands (LR+, LR-) oder des mindestens einen Widerstandswerts mittels Vergleichens einer Signalspannungsgröße (SG+, SG-) der Datenkommunikationsleitung (6) und einer Leistungsspannungsgröße (LG+, LG-) des mindestens einen Packleistungskontakts (2+, 2-) oder des mindestens einen Geräteleistungskontakts (5+, 5-) miteinander, wobei die Signalspannungsgröße (SG+, SG-) oder die Leistungsspannungsgröße (LG+, LG-) von mindestens einem Spannungsabfall (ΔU+, ΔU-) verursacht durch den Leistungsstrom (LI) und den mindestens einen Leistungskontaktwiderstand (LR+, LR-) abhängt.

2. Verfahren nach Anspruch 1, wobei das Verfahren aufweist:
- Bestimmen des mindestens eines Leistungskontaktwiderstands (LR+, LR-) oder des mindestens einen Widerstandswerts mittels Bestimmens des Leistungsstroms (LI).

3. Verfahren nach einem der vorhergehenden Ansprüche,
- wobei die Datenkommunikationsleitung (6) von dem mindestens einen Packleistungskontakt (2+, 2-) und dem mindestens einen Geräteleistungskontakt (5+, 5-) verschieden ist,
- insbesondere wobei der Akkupack (1) einen von dem mindestens einen Packleistungskontakt (2+, 2-) verschiedenen Packdatenkontakt (7) aufweist, wobei das Bearbeitungsgerät (3) oder das Ladegerät (4) einen von dem mindestens einen Geräteleistungskontakt (5+, 5-) verschiedenen Gerätedatenkontakt (8) aufweist, wobei der Packdatenkontakt (7) und der Gerätedatenkontakt (8) einander berühren, und wobei die Datenkommunikationsleitung (6) mindestens teilweise durch die Berührung des Packdatenkontakts (7) und des Gerätedatenkontakts (8) hergestellt ist.

4. Verfahren nach einem der vorhergehenden Ansprüche, wobei das Verfahren aufweist:
- Vergleichen mittels Ermittelns einer Abweichung (DI-, DI+), insbesondere einer Differenz (DI-, DI+), der Signalspannungsgröße (SG+, SG-) und der Leistungsspannungsgröße (LG+, LG-) voneinander.

5. Verfahren nach einem der vorhergehenden Ansprüche,
- wobei die Leistungsspannungsgröße (LG+, LG-) ein Leistungsspannungspotential (LP+, LP-), insbesondere ein Minus-Leistungsspannungspotential (LP-) und/oder ein Plus-Leistungsspannungspotential (LP+), des Packleistungskontakts (2+, 2-), insbesondere eines Minus-Packleistungskontakts (2-) und/oder eines Plus-Packleistungskontakts (2+), und/oder eine Leistungsspannungsdifferenz (LDI) zwischen dem Plus-Leistungsspannungspotential (LP+) des Plus-Packleistungskontakts (2+) und dem Minus-Leistungsspannungspotential (LP-) des Minus-Packleistungskontakts (2-) ist, oder
- wobei die Leistungsspannungsgröße (LG+, LG-) ein Leistungsspannungspotential (LP+, LP-), insbesondere ein Minus-Leistungsspannungspotential (LP-) und/oder ein Plus-Leistungsspannungspotential (LP+), des Geräteleistungskontakts (5+, 5-), insbesondere eines Minus-Geräteleistungskontakts (5-) und/oder eines Plus-Geräteleistungskontakts (5+), und/oder eine Leistungsspannungsdifferenz (LDI) zwischen dem Plus-Leistungsspannungspotential (LP+) des Plus-Geräteleistungskontakts (5+) und dem Minus-Leistungsspannungspotential (LP-) des Minus-Geräteleistungskontakts (5-) ist.

6. Verfahren nach einem der vorhergehenden Ansprüche,
- wobei die Signalspannungsgröße (SG+, SG-) ein Signalspannungspegel (low, high), insbesondere ein niedriger Signalspannungspegel (low) oder ein hoher Signalspannungspegel (high), der Datenkommunikationsleitung (6) und/oder eine Signalspannungsdifferenz (SDI) zwischen dem hohen Signalspannungspegel (high) und dem niedrigen Signalspannungspegel (low) ist.

7. Verfahren nach Ansprüchen 5 und 6, wobei das Verfahren aufweist:
- Bestimmen eines Leistungskontaktwiderstands (LR-) zwischen einem Packleistungskontakt (2-) des Akkupacks (1) und einem Geräteleistungskontakt (5-) des Bearbeitungsgeräts (3) oder des Ladegeräts (4) oder eines dem Leistungskontaktwiderstand korrespondierenden Widerstandswerts mittels Vergleichens des Signalspannungspegels (low) und des Leistungsspannungspotentials (LP-) miteinander, wobei der Signalspannungspegel (low) oder das Leistungsspannungspotential (LP-) von einem Spannungsabfall (ΔU-) verursacht durch den Leistungsstrom (LI) und den Leistungskontaktwiderstand (LR-) abhängt, und/oder
- Bestimmen eines Leistungskontaktwiderstands (LR+) zwischen einem Packleistungskontakt (2+) des Akkupacks (1) und einem Geräteleistungskontakt (5+) des Bearbeitungsgeräts (3) oder des Ladegeräts (4) oder eines dem Leistungskontaktwiderstand korrespondierenden Widerstandswerts mittels Vergleichens der Signalspannungsdifferenz (SDI) und der Leistungsspannungsdifferenz (LDI) miteinander, wobei die Signalspannungsdifferenz (SDI) oder die Leistungsspannungsdifferenz (LDI) von mindestens einem Spannungsabfall (ΔU+, ΔU-) verursacht durch den Leistungsstrom (LI) und den mindestens einen Leistungskontaktwiderstand (LR+, LR-) abhängt.

8. Verfahren nach einem der vorhergehenden Ansprüche,
- wobei die Signalspannungsgröße (SG+, SG-) auf ein Leistungsspannungspotential (LP), insbesondere ein Minus-Leistungsspannungspotential (LP-) und/oder ein Plus-Leistungsspannungspotential, des Geräteleistungskontakts (5-), insbesondere eines Minus-Geräteleistungskontakts (5-) und/oder eines Plus-Geräteleistungskontakts, referenziert ist und/oder von einer Leistungsspannungsdifferenz (LDI) zwischen dem Plus-Leistungsspannungspotential (LP+) des Plus-Geräteleistungskontakts (5+) und dem Minus-Leistungsspannungspotential (LP-) des Minus-Geräteleistungskontakts (5-) abhängt, oder
- wobei die Signalspannungsgröße (SG+, SG-) auf ein Leistungsspannungspotential (LP), insbesondere ein Minus-Leistungsspannungspotential (LP-) und/oder ein Plus-Leistungsspannungspotential, des Packleistungskontakts (2-), insbesondere eines Minus-Packleistungskontakts (2-) und/oder eines Plus-Packleistungskontakts, referenziert ist und/oder von einer Leistungsspannungsdifferenz (LDI) zwischen dem Plus-Leistungsspannungspotential (LP+) des Plus-Packleistungskontakts (2+) und dem Minus-Leistungsspannungspotential (LP-) des Minus-Packleistungskontakts (2-) abhängt.

9. Verfahren nach einem der vorhergehenden Ansprüche,
- wobei die Datenkommunikationsleitung (6) mit einem Signalausgang (9A) eines Senders (9), insbesondere einer Verstärkerschaltung (10), insbesondere des Bearbeitungsgeräts (3) oder des Ladegeräts (4) oder des Akkupacks (2), elektrisch verbunden ist,
- wobei mindestens ein Versorgungsspannungspotential (9P+, 9P-) des Senders (9) von mindestens einem Spannungsabfall (ΔU+, ΔU-) verursacht durch den Leistungsstrom (LI) und den mindestens einen Leistungskontaktwiderstand (LR+, LR-) abhängt, insbesondere und wobei der Sender (9) einen Versorgungsspannungsdurchgriff aufweist, und/oder
- wobei mindestens ein Versorgungsspannungspotential (9P+, 9P) des Senders (9) auf mindestens ein Leistungsspannungspotential (LP+, LP-) des mindestens einen Geräteleistungskontakts (5+, 5-) oder mindestens ein Leistungsspannungspotential (LP+, LP-) des mindestens einen Packleistungskontakts (2+, 2-) referenziert ist, insbesondere das mindestens eine Leistungsspannungspotential (LP+, LP-) ist, und/oder
- wobei mindestens ein Versorgungsspannungseingang (9E+, 9E-) des Senders (9) mit dem mindestens einen Geräteleistungskontakt (5+, 5-) oder dem mindestens einen Packleistungskontakt (2+, 2-) elektrisch verbunden, insbesondere parallelgeschaltet, ist.

10. Verfahren nach einem der vorhergehenden Ansprüche,
- wobei das Datenkommunikationssignal (DS) eine Betriebsdaten-Information (BI), eine Drehzahl-Information (nI), eine Strom-Information (SI), eine Spannungs-Information (UI), eine Leistungs-Information (LI), eine Entladungs-Information (EI), eine Aufladungs-Information (AI), eine Temperatur-Information (TI), eine Zustands-Information (ZI), eine Fehler-Information (FI) und/oder eine Identifikator-Information (II) aufweist.

11. Verfahren nach einem der vorhergehenden Ansprüche,
- wobei der mindestens eine Packleistungskontakt (2+, 2-) und/oder der mindestens eine Geräteleistungskontakt (5+, 5-) ein Steckverbinder (12) ist/sind.

12. Verfahren nach einem der vorhergehenden Ansprüche,
- wobei eine Nennspannung (NSP) des Akkupacks (1), des Bearbeitungsgeräts (3) und/oder des Ladegeräts (4) minimal 18 V, insbesondere minimal 30 V, und/oder maximal 72 V, insbesondere maximal 54 V, ist, und/oder
- wobei ein maximaler Leistungsstrom (mLI) des Akkupacks (1), des Bearbeitungsgeräts (3) und/oder des Ladegeräts (4) minimal 1 A, insbesondere minimal 1,5 A, und/oder maximal 1000 A, insbesondere maximal 750 A, ist, und/oder
- wobei eine maximale Leistung (mL) des Akkupacks (1), des Bearbeitungsgeräts (3) und/oder des Ladegeräts (4) minimal 1 kW, insbesondere minimal 2 kW, und/oder maximal 10 kW, insbesondere maximal 5 kW, ist, und/oder
- wobei ein maximaler Energieinhalt (mEI) des Akkupacks (1) minimal 100 Wh, insbesondere minimal 200 Wh, und/oder maximal 4000 Wh, insbesondere maximal 2000 Wh, ist.

13. Verfahren nach einem der vorhergehenden Ansprüche, wobei das Verfahren aufweist:
- Ausgeben und/oder Übertragen einer Information (Info) über den mindestens einen bestimmten Leistungskontaktwiderstand (LR+, LR-) oder den mindestens einen bestimmten Widerstandswert, insbesondere falls der mindestens eine bestimmte Leistungskontaktwiderstand (LR+, LR-) oder der mindestens eine bestimmte Widerstandswert einen Widerstandsgrenzwert (RG) erreicht oder überschreitet, und/oder
- falls der mindestens eine bestimmte Leistungskontaktwiderstand (LR+, LR-) oder der mindestens eine bestimmte Widerstandswert einen Widerstandsgrenzwert (RG) erreicht oder überschreitet, Absenken einer maximal freigegebenen Leistung (mfL) und/oder eines maximal freigegebenen Leistungsstroms (mfLI), insbesondere Abschalten des Akkupacks (1), des Bearbeitungsgeräts (3) und/oder des Ladegeräts (4).

14. System (100) zum Bestimmen mindestens eines Leistungskontaktwiderstands (LR+, LR) zwischen mindestens einem Packleistungskontakt (2+, 2-) eines Akkupacks (1) und mindestens einem Geräteleistungskontakt (5+, 5-) eines elektrisch angetriebenen Bearbeitungsgeräts (3) oder eines Ladegeräts (4) oder mindestens eines dem mindestens einen Leistungskontaktwiderstand korrespondierenden Widerstandswerts, insbesondere zum Ausführen eines Verfahrens nach einem der vorhergehenden Ansprüche,
- wobei der mindestens eine Packleistungskontakt (2+, 2-) und der mindestens eine Geräteleistungskontakt (5+, 5-) einander berühren und mit einem Leistungsstrom (LI) belastet sind, und
- wobei der Akkupack (1) und das Bearbeitungsgerät (3) oder das Ladegerät (4) mittels einer Datenkommunikationsleitung (6) zum Übertragen eines Datenkommunikationssignals (DS) elektrisch verbunden sind,
- wobei das System (100) zum Bestimmen des mindestens einen Leistungskontaktwiderstands (LR+, LR-) oder des mindestens einen Widerstandswerts mittels Vergleichens einer Signalspannungsgröße (SG+, SG-) der Datenkommunikationsleitung (6) und einer Leistungsspannungsgröße (LG+, LG-) des mindestens einen Packleistungskontakts (2+, 2-) oder des mindestens einen Geräteleistungskontakts (5+, 5-) miteinander ausgebildet ist, wobei die Signalspannungsgröße (SG+, SG-) oder die Leistungsspannungsgröße (LG+, LG-) von mindestens einem Spannungsabfall (ΔU+, ΔU-) verursacht durch den Leistungsstrom (LI) und den mindestens einen Leistungskontaktwiderstand (LR+, LR-) abhängt.

15. System (100) nach Anspruch 14,
- wobei das System (100) den Akkupack (1), das Bearbeitungsgerät (3) und/oder das Ladegerät (4) aufweist.

## Claims

1. Method for determining at least one power contact resistance (LR+, LR-) between at least one pack power contact (2+, 2-) of a battery pack (1) and at least one apparatus power contact (5+, 5-) of an electrically driven work apparatus (3) or of a charging apparatus (4) or at least one resistance value corresponding to the at least one power contact resistance,
- wherein the at least one pack power contact (2+, 2-) and the at least one apparatus power contact (5+, 5-) touch one another and are loaded with a power current (LI), and
- wherein the battery pack (1) and the work apparatus (3) or the charging apparatus (4) are electrically connected by means of a data communication line (6) for transmitting a data communication signal (DS),
- wherein the method comprises: determining the at least one power contact resistance (LR+, LR-) or the at least one resistance value by means of comparing a signal voltage variable (SG+, SG-) of the data communication line (6) and a power voltage variable (LG+, LG-) of the at least one pack power contact (2+, 2-) or of the at least one apparatus power contact (5+, 5-) with one another, wherein the signal voltage variable (SG+, SG-) or the power voltage variable (LG+, LG-) is dependent on at least one voltage drop (ΔU+, ΔU-) caused by the power current (LI) and the at least one power contact resistance (LR+, LR-) .

2. Method according to Claim 1, wherein the method comprises:
- determining the at least one power contact resistance (LR+, LR-) or the at least one resistance value by means of determining the power current (LI).

3. Method according to either of the preceding claims,
- wherein the data communication line (6) is different from the at least one pack power contact (2+, 2-) and the at least one apparatus power contact (5+, 5-),
- in particular wherein the battery pack (1) comprises a pack data contact (7), which is different from the at least one pack power contact (2+, 2-), wherein the work apparatus (3) or the charging apparatus (4) comprises an apparatus data contact (8), which is different from the at least one apparatus power contact (5+, 5-), wherein the pack data contact (7) and the apparatus data contact (8) touch one another, and wherein the data communication line (6) is at least partly produced by the touching of the pack data contact (7) and the apparatus data contact (8).

4. Method according to any of the preceding claims, wherein the method comprises:
- comparing by means of ascertaining a deviation (DI-, DI+), in particular a difference (DI-, DI+), of the signal voltage variable (SG+, SG-) and the power voltage variable (LG+, LG-) from one another.

5. Method according to any of the preceding claims,
- wherein the power voltage variable (LG+, LG-) is a power voltage potential (LP+, LP-), in particular a negative power voltage potential (LP-) and/or a positive power voltage potential (LP+), of the pack power contact (2+, 2-), in particular of a negative pack power contact (2-) and/or of a positive pack power contact (2+), and/or a power voltage difference (LDI) between the positive power voltage potential (LP+) of the positive pack power contact (2+) and the negative power voltage potential (LP-) of the negative pack power contact (2-), or
- wherein the power voltage variable (LG+, LG-) is a power voltage potential (LP+, LP-), in particular a negative power voltage potential (LP-) and/or a positive power voltage potential (LP+), of the apparatus power contact (5+, 5-), in particular of a negative apparatus power contact (5-) and/or of a positive apparatus power contact (5+), and/or a power voltage difference (LDI) between the positive power voltage potential (LP+) of the positive apparatus power contact (5+) and the negative power voltage potential (LP-) of the negative apparatus power contact (5-).

6. Method according to any of the preceding claims,
- wherein the signal voltage variable (SG+, SG-) is a signal voltage level (low, high), in particular a low signal voltage level (low) or a high signal voltage level (high), of the data communication line (6) and/or a signal voltage difference (SDI) between the high signal voltage level (high) and the low signal voltage level (low).

7. Method according to Claims 5 and 6, wherein the method comprises:
- determining a power contact resistance (LR-) between a pack power contact (2-) of the battery pack (1) and an apparatus power contact (5-) of the work apparatus (3) or of the charging apparatus (4) or a resistance value corresponding to the power contact resistance by means of comparing the signal voltage level (low) and the power voltage potential (LP-) with one another, wherein the signal voltage level (low) or the power voltage potential (LP-) is dependent on a voltage drop (ΔU-) caused by the power current (LI) and the power contact resistance (LR-), and/or
- determining a power contact resistance (LR+) between a pack power contact (2+) of the battery pack (1) and an apparatus power contact (5+) of the work apparatus (3) or of the charging apparatus (4) or a resistance value corresponding to the power contact resistance by means of comparing the signal voltage difference (SDI) and the power voltage difference (LDI) with one another, wherein the signal voltage difference (SDI) or the power voltage difference (LDI) is dependent on at least one voltage drop (ΔU+, ΔU-) caused by the power current (LI) and the at least one power contact resistance (LR+, LR-).

8. Method according to any of the preceding claims,
- wherein the signal voltage variable (SG+, SG-) is referenced to a power voltage potential (LP-), in particular a negative power voltage potential (LP-) and/or a positive power voltage potential, of the apparatus power contact (5-), in particular of a negative apparatus power contact (5-) and/or of a positive apparatus power contact, and/or is dependent on a power voltage difference (LDI) between the positive power voltage potential (LP+) of the positive apparatus power contact (5+) and the negative power voltage potential (LP-) of the negative apparatus power contact (5-), or
- wherein the signal voltage variable (SG+, SG-) is referenced to a power voltage potential (LP-), in particular a negative power voltage potential (LP-) and/or a positive power voltage potential, of the pack power contact (2-), in particular of a negative pack power contact (2-) and/or of a positive pack power contact, and/or is dependent on a power voltage difference (LDI) between the positive power voltage potential (LP+) of the positive pack power contact (2+) and the negative power voltage potential (LP-) of the negative pack power contact (2-).

9. Method according to any of the preceding claims,
- wherein the data communication line (6) is electrically connected to a signal output (9A) of a transmitter (9), in particular of an amplifier circuit (10), in particular of the work apparatus (3) or of the charging apparatus (4) or of the battery pack (2),
- wherein at least one supply voltage potential (9P+, 9P-) of the transmitter (9) is dependent on at least one voltage drop (ΔU+, ΔU-) caused by the power current (LI) and the at least one power contact resistance (LR+, LR-), and in particular wherein the transmitter (9) has a power supply rejection ratio, and/or
- wherein at least one supply voltage potential (9P+, 9P) of the transmitter (9) is referenced to at least one power voltage potential (LP+, LP-) of the at least one apparatus power contact (5+, 5-) or at least one power voltage potential (LP+, LP-) of the at least one pack power contact (2+, 2-), in particular is the at least one power voltage potential (LP+, LP-), and/or
- wherein at least one supply voltage input (9E+, 9E-) of the transmitter (9) is electrically connected to, in particular connected in parallel with, the at least one apparatus power contact (5+, 5-) or the at least one pack power contact (2+, 2-).

10. Method according to any of the preceding claims,
- wherein the data communication signal (DS) comprises operating data information (BI), rotational speed information (nI), current information (SI), voltage information (UI), power information (LI), discharge information (EI), charging information (AI), temperature information (TI), state information (ZI), fault information (FI) and/or identifier information (II) .

11. Method according to any of the preceding claims,
- wherein the at least one pack power contact (2+, 2-) and/or the at least one apparatus power contact (5+, 5-) are/is a plug connector (12).

12. Method according to any of the preceding claims,
- wherein a rated voltage (NSP) of the battery pack (1), of the work apparatus (3) and/or of the charging apparatus (4) is a minimum of 18 V, in particular a minimum of 30 V, and/or a maximum of 72 V, in particular a maximum of 54 V, and/or
- wherein a maximum power current (mLI) of the battery pack (1), of the work apparatus (3) and/or of the charging apparatus (4) is a minimum of 1 A, in particular a minimum of 1.5 A, and/or a maximum of 1000 A, in particular a maximum of 750 A, and/or
- wherein a maximum power (mL) of the battery pack (1), of the work apparatus (3) and/or of the charging apparatus (4) is a minimum of 1 kW, in particular a minimum of 2 kW, and/or a maximum of 10 kW, in particular a maximum of 5 kW, and/or
- wherein a maximum energy content (mEI) of the battery pack (1) is a minimum of 100 Wh, in particular a minimum of 200 Wh, and/or a maximum of 4000 Wh, in particular a maximum of 2000 Wh.

13. Method according to any of the preceding claims, wherein the method comprises:
- outputting and/or transmitting information (Info) about the at least one power contact resistance (LR+, LR-) determined or the at least one resistance value determined, in particular if the at least one power contact resistance (LR+, LR-) determined or the at least one resistance value determined reaches or exceeds a resistance limit value (RG), and/or
- if the at least one power contact resistance (LR+, LR-) determined or the at least one resistance value determined reaches or exceeds a resistance limit value (RG), decreasing a maximum released power (mfL) and/or a maximum released power current (mfLI), in particular switching off the battery pack (1), the work apparatus (3) and/or the charging apparatus (4).

14. System (100) for determining at least one power contact resistance (LR+, LR-) between at least one pack power contact (2+, 2-) of a battery pack (1) and at least one apparatus power contact (5+, 5-) of an electrically driven work apparatus (3) or of a charging apparatus (4) or at least one resistance value corresponding to the at least one power contact resistance, in particular for carrying out a method according to any of the preceding claims,
- wherein the at least one pack power contact (2+, 2-) and the at least one apparatus power contact (5+, 5-) touch one another and are loaded with a power current (LI), and
- wherein the battery pack (1) and the work apparatus (3) or the charging apparatus (4) are electrically connected by means of a data communication line (6) for transmitting a data communication signal (DS),
- wherein the system (100) is designed for determining the at least one power contact resistance (LR+, LR-) or the at least one resistance value by means of comparing a signal voltage variable (SG+, SG-) of the data communication line (6) and a power voltage variable (LG+, LG-) of the at least one pack power contact (2+, 2-) or of the at least one apparatus power contact (5+, 5-) with one another, wherein the signal voltage variable (SG+, SG-) or the power voltage variable (LG+, LG-) is dependent on at least one voltage drop (ΔU+, ΔU-) caused by the power current (LI) and the at least one power contact resistance (LR+, LR-) .

15. System (100) according to Claim 14,
- wherein the system (100) comprises the battery pack (1), the work apparatus (3) and/or the charging apparatus (4).

## Revendications

1. Procédé de détermination d'au moins une résistance de contact de puissance (LR+, LR-) entre au moins un contact de puissance de bloc (2+, 2-) d'un bloc-batterie (1) et au moins un contact de puissance d'appareil (5+, 5-) d'un appareil de traitement à entraînement électrique (3) ou d'un appareil de charge (4) ou d'au moins une valeur de résistance correspondant à ladite au moins une résistance de contact de puissance,
- ledit au moins un contact de puissance de bloc (2+, 2-) et ledit au moins un contact de puissance d'appareil (5+, 5-) étant en contact l'un avec l'autre et étant chargés avec un courant de puissance (LI), et
- le bloc-batterie (1) et l'appareil de traitement (3) ou l'appareil de charge (4) étant reliés électriquement au moyen d'une ligne de communication de données (6) pour transmettre un signal de communication de données (DS),
- le procédé comprenant : la détermination de ladite au moins une résistance de contact de puissance (LR+, LR) ou de ladite au moins une valeur de résistance par comparaison l'une à l'autre d'une grandeur de tension de signal (SG+, SG-) de la ligne de communication de données (6) et d'une grandeur de tension de puissance (LG+, LG-) dudit au moins un contact de puissance de bloc (2+, 2-) ou dudit au moins un contact de puissance d'appareil (5+, 5-), lad grandeur de tension de signal (SG+, SG-) ou la grandeur de tension de puissance (LG+, LG-) dépendant d'au moins une chute de tension (ΔU+, ΔU-) provoquée par le courant de puissance (LI) et par ladite au moins une résistance de contact de puissance (LR+, LR-).

2. Procédé selon la revendication 1, le procédé comprenant :
- la détermination de ladite au moins une résistance de contact de puissance (LR+, LR-) ou de ladite au moins une valeur de résistance par détermination du courant de puissance (LI).

3. Procédé selon l'une des revendications précédentes,
- la ligne de communication de données (6) étant différente dudit au moins un contact de puissance de bloc (2+, 2-) et dudit au moins un contact de puissance d'appareil (5+, 5-),
- le bloc-batterie (1) comportant notamment un contact de données de bloc (7) différent dudit au moins un contact de puissance de bloc (2+, 2-), l'appareil de traitement (3) ou l'appareil de charge (4) comportant un contact de données d'appareil (8) différent dudit au moins un contact de puissance d'appareil (5+, 5-), le contact de données de bloc (7) et le contact de données d'appareil (8) étant en contact l'un avec l'autre, et la ligne de communication de données (6) étant établie au moins partiellement par la mise en contact du contact de données de bloc (7) et du contact de données d'appareil (8) .

4. Procédé selon l'une des revendications précédentes, le procédé comprenant :
- la comparaison l'une à l'autre, par détermination d'un écart (DI-, DI+), notamment d'une différence (DI-, DI+), de la grandeur de tension de signal (SG+, SG-) et de la grandeur de tension de puissance (LG+, LG-).

5. Procédé selon l'une des revendications précédentes,
- la grandeur de tension de puissance (LG+, LG-) étant un potentiel de tension de puissance (LP+, LP-), notamment un potentiel de tension de puissance négatif (LP-) et/ou un potentiel de tension de puissance positif (LP+), du contact de puissance de bloc (2+, 2-), notamment d'un contact de puissance de bloc négatif (2-) et/ou d'un contact de puissance de bloc positif (2+), et/ou étant une différence de tension de puissance (LDI) entre le potentiel de tension de puissance positif (LP+) du contact de puissance de bloc positif (2+) et le potentiel de tension de puissance négatif (LP-) du contact de puissance de bloc négatif (2-), ou la grandeur de tension de puissance (LG+, LG-) étant un potentiel de tension de puissance (LP+, LP-), notamment un potentiel de tension de puissance négatif (LP-) et/ou un potentiel de tension de puissance positif (LP+), du contact de puissance d'appareil (5+, 5-), notamment d'un contact de puissance d'appareil négatif (5-) et/ou d'un contact de puissance d'appareil positif (5+), et/ou étant une différence de tension de puissance (LDI) entre le potentiel de tension de puissance positif (LP+) du contact de puissance d'appareil positif (5+) et le potentiel de tension de puissance négatif (LP-) du contact de puissance d'appareil négatif (5-).

6. Procédé selon l'une des revendications précédentes,
- la grandeur de tension de signal (SG+, SG-) étant un niveau de tension de signal (low, high), notamment un niveau de tension de signal bas (low) ou un niveau de tension de signal haut (high), de la ligne de communication de données (6) et/ou étant une différence de tension de signal (SDI) entre le niveau de tension de signal haut (high) et le niveau de tension de signal bas (low).

7. Procédé selon la revendication 5 ou 6, le procédé comprenant :
- la détermination d'une résistance de contact de puissance (LR-) entre un contact de puissance de bloc (2-) du bloc-batterie (1) et un contact de puissance d'appareil (5-) de l'appareil de traitement (3) ou de l'appareil de charge (4) ou une valeur de résistance correspondant à la résistance de contact de puissance par comparaison l'un à l'autre du niveau de tension de signal (low) et du potentiel de tension de puissance (LP-), le niveau de tension de signal (low) ou le potentiel de tension de puissance (LP-) dépendant d'une chute de tension (ΔU-) provoquée par le courant de puissance (LI) et par la résistance de contact de puissance (LR-), et/ou
- la détermination d'une résistance de contact de puissance (LR+) entre un contact de puissance de bloc (2+) du bloc-batterie (1) et un contact de puissance d'appareil (5+) de l'appareil de traitement (3) ou de l'appareil de charge (4) ou d'une valeur de résistance correspondant à la résistance de contact de puissance par comparaison l'une à l'autre de la différence de tension de signal (SDI) et de la différence de tension de puissance (LDI), la différence de tension de signal (SDI) ou la différence de tension de puissance (LDI) dépendant d'au moins une chute de tension (ΔU+, ΔU-) provoquée par le courant de puissance (LI) et par ladite au moins une résistance de contact de puissance (LR+, LR-).

8. Procédé selon l'une des revendications précédentes,
- la grandeur de tension de signal (SG+, SG-) étant référencée à un potentiel de tension de puissance (LP-), notamment à un potentiel de tension de puissance négatif (LP-) et/ou à un potentiel de tension de puissance positif, du contact de puissance d'appareil (5-), notamment d'un contact de puissance d'appareil négatif (5-) et/ou d'un contact de puissance d'appareil positif et/ou dépendant d'une différence de tension de puissance (LDI) entre le potentiel de tension de puissance positif (LP+) du contact de puissance d'appareil positif (5+) et le potentiel de tension de puissance négatif (LP-) du contact de puissance d'appareil négatif (5-), ou
- la grandeur de tension de signal (SG+, SG-) étant référencée à un potentiel de tension de puissance (LP-), notamment à un potentiel de tension de puissance négatif (LP-) et/ou à un potentiel de tension de puissance positif, du contact de puissance de bloc (2-), notamment d'un contact de puissance de bloc négatif (2-) et/ou d'un contact de puissance de bloc positif et/ou dépendant d'une différence de tension de puissance (LDI) entre le potentiel de tension de puissance positif (LP+) du contact de puissance de bloc positif (2+) et le potentiel de tension de puissance négatif (LP-) du contact de puissance de bloc négatif (2-).

9. Procédé selon l'une des revendications précédentes,
- la ligne de communication de données (6) étant reliée électriquement à une sortie de signal (9A) d'un émetteur (9), notamment d'un circuit amplificateur (10), notamment de l'appareil de traitement (3) ou de l'appareil de charge (4) ou du bloc-batterie (2),
- au moins un potentiel de tension d'alimentation (9P+, 9P-) de l'émetteur (9) dépendant notamment d'au moins une chute de tension (ΔU+, ΔU-) provoquée par le courant de puissance (LI) et par ladite au moins une résistance de contact de puissance (LR+, LR-), et l'émetteur (9) comportant une traversée de tension d'alimentation, et/ou
- au moins un potentiel de tension d'alimentation (9P+, 9P) de l'émetteur (9) étant référencé à au moins un potentiel de tension de puissance (LP+, LP-) dudit au moins un contact de puissance d'appareil (5+, 5-) ou à au moins un potentiel de tension de puissance (LP+, LP-) dudit au moins un contact de puissance de bloc (2+, 2-), notamment audit au moins un potentiel de tension de puissance (LP+, LP-), et/ou
- au moins une entrée de tension d'alimentation (9E+, 9E-) de l'émetteur (9) étant reliée électriquement, notamment connectée en parallèle, audit au moins un contact de puissance d'appareil (5+, 5-) ou audit au moins un contact de puissance de bloc (2+, 2-).

10. Procédé selon l'une des revendications précédentes,
- le signal de communication de données (DS) comprenant une information de données de fonctionnement (BI), une information de vitesse de rotation (nI), une information de courant (SI), une information de tension (UI), une information de puissance (LI), une information de décharge (EI), une information de charge (AI), une information de température (TI), une information d'état (ZI), une information de défaut (FI) et/ou une information d'identifiant (II).

11. Procédé selon l'une des revendications précédentes,
- ledit au moins un contact de puissance de bloc (2+, 2-) et/ou ledit au moins un contact de puissance d'appareil (5+, 5-) étant un connecteur (12).

12. Procédé selon l'une des revendications précédentes,
- une tension nominale (NSP) du bloc-batterie (1), de l'appareil de traitement (3) et/ou de l'appareil de charge (4) étant au minimum de 18 V, notamment au minimum de 30 V, et/ou au maximum de 72 V, notamment au maximum de 54 V, et/ou
- un courant de puissance maximal (mLI) du bloc-batterie (1), de l'appareil de traitement (3) et/ou de l'appareil de charge (4) étant au minimum de 1 A, notamment au minimum de 1,5 A, et/ou au maximum de 1000 A, notamment au maximum de 750 A, et/ou
- une puissance maximale (mL) du bloc-batterie (1), de l'appareil de traitement (3) et/ou de l'appareil de charge (4) étant au minimum de 1 kW, notamment au minimum de 2 kW, et/ou au maximum de 10 kW, notamment au maximum de 5 kW, et/ou
- un contenu énergétique maximal (mEI) du bloc-batterie (1) étant au minimum de 100 Wh, notamment au minimum de 200 Wh, et/ou au maximum de 4000 Wh, notamment au maximum de 2000 Wh.

13. Procédé selon l'une des revendications précédentes, le procédé comprenant :
- la fourniture et/ou la transmission d'une information (Info) concernant ladite au moins une résistance de contact de puissance (LR+, LR-) déterminée ou ladite au moins une valeur de résistance déterminée, notamment dans le cas où ladite au moins une résistance de contact de puissance (LR+, LR-) déterminée ou ladite au moins une valeur de résistance déterminée atteint ou dépasse une valeur limite de résistance (RG), et/ou
- dans le cas où ladite au moins une résistance de contact de puissance (LR+, LR-) déterminée ou ladite au moins une valeur de résistance déterminée atteint ou dépasse une valeur limite de résistance (RG), la réduction d'une puissance maximale délivrée (mfL) et/ou d'un courant de puissance maximal délivré (mfLI), notamment la déconnexion du bloc-batterie (1), de l'appareil de traitement (3) et/ou de l'appareil de charge (4).

14. Système (100) de détermination d'au moins une résistance de contact de puissance (LR+, LR-) entre au moins un contact de puissance de bloc (2+, 2-) d'un bloc-batterie (1) et au moins un contact de puissance d'appareil (5+, 5-) d'un appareil de traitement (3) ou d'un appareil de charge (4) à entraînement électrique, ou d'au moins une valeur de résistance correspondant à ladite au moins une résistance de contact de puissance, notamment pour mettre en œuvre un procédé selon l'une des revendications précédentes,
- ledit au moins un contact de puissance de bloc (2+, 2-) et ledit au moins un contact de puissance d'appareil (5+, 5-) étant en contact l'un avec l'autre et étant chargés avec un courant de puissance (LI), et
- le bloc-batterie (1) et l'appareil de traitement (3) ou l'appareil de charge (4) étant reliés électriquement au moyen d'une ligne de communication de données (6) pour transmettre un signal de communication de données (DS),
- le système (100) étant conçu pour déterminer ladite au moins une résistance de contact de puissance (LR+, LR-) ou ladite au moins une valeur de résistance par comparaison l'une à l'autre d'une grandeur de tension de signal (SG+, SG-) de la ligne de communication de données (6) et d'une grandeur de tension de puissance (LG+, LG-) dudit au moins un contact de puissance de bloc (2+, 2-) ou dudit au moins un contact de puissance d'appareil (5+, 5-), la grandeur de tension de signal (SG+, SG-) ou la grandeur de tension de puissance (LG+, LG-) dépendant d'au moins une chute de tension (ΔU+, ΔU-) provoquée par le courant de puissance (LI) et par ladite au moins une résistance de contact de puissance (LR+, LR-).

15. Système (100) selon la revendication 14,
- le système (100) comportant le bloc-batterie (1), l'appareil de traitement (3) et/ou l'appareil de charge (4) .
